(19) **Europäisches Patentamt European Patent Office Office européen des brevets**

(11) **EP 4 016 531 B1**

(12) **FASCICULE DE BREVET EUROPEEN**

(45) Date de publication et mention de la délivrance du brevet:
**05.02.2025 Bulletin 2025/06**

(21) Numéro de dépôt: **21213966.1**

(22) Date de dépôt: **13.12.2021**

(51) Classification Internationale des Brevets (IPC):
***G11C 13/00*** *(2006.01)*

(52) Classification Coopérative des Brevets (CPC):
**G11C 13/003; G11C 13/004; G11C 13/0061;**
G11C 2013/0045; G11C 2213/76

(54) **MÉMOIRE COMPRENANT UNE MATRICE DE CELLULES MÉMOIRES RÉSISTIVES, ET PROCÉDÉ D'INTERFAÇAGE ASSOCIÉ**

SPEICHER MIT EINER MATRIX AUS RESISTIVEN SPEICHERZELLEN UND ENTSPRECHENDES SCHNITTSTELLENVERBINDUNGSVERFAHREN

MEMORY COMPRISING AN ARRAY OF RESISTIVE MEMORIES CELLS, AND ASSOCIATED INTERFACE METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.12.2020 FR 2013374**

(43) Date de publication de la demande:
**22.06.2022 Bulletin 2022/25**

(73) Titulaires:
• **Commissariat à l'Energie Atomique et aux Energies Alternatives**
**75015 Paris (FR)**
• **Weebit Nano Ltd**
**4527713 Hod-HaSharon (IL)**

(72) Inventeurs:
• **VERDY, Anthonin**
**38000 Grenoble (FR)**
• **MOLAS, Gabriel**
**38054 Grenoble Cedex 9 (FR)**
• **TROTTI, Paola**
**38054 Grenoble Cedex 9 (FR)**
• **REGEV, Amir**
**71708 Modiin (IL)**

(74) Mandataire: **Cabinet Camus Lebkiri**
**25 rue de Maubeuge**
**75009 Paris (FR)**

(56) Documents cités:
**EP-B1- 1 642 298    US-A1- 2013 329 484**

**Description**

**DOMAINE TECHNIQUE**

Le domaine technique est celui de la micro-électronique, plus particulièrement celui des mémoires résistives.
L'invention concerne plus particulièrement une mémoire comprenant une matrice de cellules résistives et un dispositif électrique d'interfaçage de cette matrice.

**ARRIERE-PLAN TECHNOLOGIQUE**

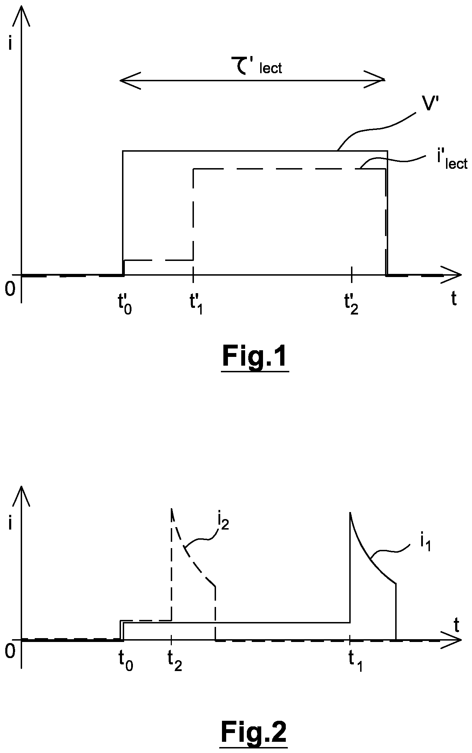

De nouveaux types de mémoires non volatiles, appelées mémoires résistives, ou parfois ReRAM (selon l'acronyme de « Resistive Random Access Memory »), ont été développés ces dernières années. Une mémoire de ce type comprend généralement une matrice de cellules mémoires, parfois appelées « points mémoire », stockant chacune une donnée, par exemple une donnée binaire. La donnée binaire en question est représentée par le niveau de résistance, soit haut, soit bas, de la cellule mémoire considérée. La donnée stockée dans une telle cellule mémoire peut aussi être une donnée pouvant prendre plus de deux valeurs différentes (par exemple quatre valeurs différentes, la donnée regroupant alors deux bits), dans le cas d'une cellule mémoire « multiniveaux ». Dans ce cas, la cellule mémoire présente une résistance égale à l'un de ses niveaux de résistance (dont le nombre est supérieur à deux), niveau qui est associé à la valeur stockée dans la cellule.
Différentes technologies sont envisageables, pour réaliser des cellules mémoire. Il peut par exemple s'agir de cellules mémoire de type filamentaire, comprenant une couche active dans laquelle un filament électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé, et de RESET, lorsque le filament est rompu à nouveau). Une telle cellule mémoire, de type filamentaire, peut par exemple être une cellule de type OxRam (selon l'acronyme anglo-saxon de « Oxide Random Access Memory »), ou de type CB-RAM (selon l'acronyme anglo-saxon de « Conductive Bridge Random Access Memory »). Les cellules mémoire résistives en question peuvent aussi être des cellules de type PCRAM (pour « Phase Change Random Access Memory »), dans lesquelles un changement de phase amorphe-cristallin s'accompagne d'un changement de résistance de la cellule.
Quoiqu'il en soit, pour accéder à la donnée stockée dans l'une des cellules de la matrice, c'est-à-dire pour lire cette cellule, une technique consiste à appliquer une tension de lecture V' à la cellule en question, et à mesurer le courant électrique qui, en réponse, traverse la cellule. La valeur de courant renseigne alors sur l'état, soit hautement résistif, soit bassement résistif de la cellule mémoire. En pratique, la tension de lecture est appliquée entre, d'une part, la ligne de la matrice où se trouve la cellule à lire, et, d'autre part, la colonne de la matrice où se trouve cette cellule.
Les cellules mémoire en question sont parfois du type « 1S1R », c'est-à-dire comportant, en série : un étage « 1S », jouant le rôle d'un sélecteur et un étage « 1R » correspondant à l'élément mémoire lui-même, dans lequel est stockée la donnée (sous forme du niveau de résistance de cet élément). L'élément mémoire résistif est la partie de la cellule mémoire où est stockée la donnée (de manière non volatile), sous la forme de l'état résistif (haut ou bas) de cet élément. Comme indiqué plus haut, cet élément mémoire peut être de type filamentaire (OxRAM ou CBRAM), ou à changement de phase. Lorsqu'une tension suffisante est appliquée aux bornes de la cellule mémoire, le sélecteur devient conducteur, permettant ainsi de lire l'état de l'élément mémoire « 1R ». Le sélecteur est généralement réalisé dans une partie dite « backend » de la puce électronique comprenant la mémoire, c'est-à-dire dans une partie de cette puce réalisée lors d'une deuxième phase de fabrication de la puce (les éléments mémoire peuvent aussi être réalisés lors de cette deuxième phase, l'ensemble de la matrice faisant partie du « backend »). Une telle structure « 1S1R » a l'avantage de pouvoir être fabriquée par une technologie de type backend, avec empilement des matrices de cellules mémoire et de sélecteur. Par ailleurs, d'un point de vue électrique, cette structure permet d'injecter une densité de courant qui est généralement plus importante qu'avec une technologie frontend traditionnelle à base de transistor ou diode. Cela permet d'obtenir une densité de mémoire plus importante.
Mais lors d'une telle opération de lecture, il faut parfois attendre un certain temps entre l'instant $t'_o$ où l'on commence à appliquer la tension de lecture V', et le moment où le sélecteur bascule dans son état conducteur. Or, le délai correspondant est en partie imprévisible, susceptible de varier d'une cellule à l'autre, et d'une lecture à l'autre : dans certains cas, le basculement peut avoir lieu presque instantanément, au bout d'une ou de quelques nanosecondes seulement, tandis que dans d'autre cas, le basculement peut ne se produire qu'une trentaine ou quarantaine de nanosecondes après l'application de la tension de lecture. Ce phénomène est parfois « incubation ».
Pour pouvoir lire convenablement la cellule mémoire considérée, la tension de lecture est alors appliquée sous la forme d'une impulsion en forme de créneau, de durée $\tau'_{lect}$ relativement importante (plus longue que la valeur maximale attendue pour le délai d'incubation). Selon les cas, l'instant à partir duquel le sélecteur devient conducteur peut être situé soit au début de cette impulsion (cas de l'instant $t'_2$, sur la figure 1), soit plutôt à la fin de celle-ci (cas de l'instant $t'_1$, sur la figure 2).

Lorsque le sélecteur bascule dans son état au début de l'impulsion de lecture, par exemple à l'instant t'$_2$, un courant électrique i'$_{lect}$ traverse la cellule mémoire pendant une durée importante (i.e.: pendant presque toute la durée de l'impulsion de lecture). Cela entraine une consommation électrique importante, et peut aussi causer une forme d'altération ou des tensions mécaniques à petite échelle (un « stress ») au sein de l'élément mémoire 1R.

Des phénomènes comparables au phénomène d'incubation qui vient d'être présenté, pour lesquels il y a un délai en partie imprévisible avant un changement d'état conductif ou résistif, peuvent aussi se produire lors d'opérations d'écriture (ou, autrement dit, de programmation) d'une telle cellule mémoire.

Par ailleurs, le document US2013/329484A1 décrit un dispositif et une méthode pour réaliser l'étape d'initialisation de cellules mémoire de type OxRAM, cette étape dite de « forming » consistant à former le filament pour la première fois. L'étape de « forming » est réalisée de manière contrôlée, grâce à l'utilisation d'un condensateur de « forming ».

**RESUME**

Dans ce contexte, on propose une mémoire comprenant :

- une matrice de cellules mémoires résistives avec :

  - des pistes électriques de ligne,

  - des pistes électriques de colonne, et

  - des cellules mémoire résistives situées aux croisements entre les pistes électriques de ligne et les pistes électriques de colonne, chaque cellule mémoire étant connectée entre, d'une part, l'une des pistes électriques de ligne et, d'autre part, l'une des pistes électriques de colonne,

- la mémoire comprenant un dispositif d'interfaçage pour interfacer ladite matrice, le dispositif d'interfaçage comprenant au moins un condensateur de conversion, un dispositif de mesure de tension connecté aux bornes du condensateur de conversion, une source électrique, un premier interrupteur, un deuxième interrupteur et un module de commande, le dispositif d'interfaçage étant configuré pour exécuter les étapes suivantes :

  - étape a) : connecter le condensateur de conversion à la source au moyen du deuxième interrupteur pour charger le condensateur de conversion, puis

  - étape b) :

- déconnecter le condensateur de conversion de la source, et connecter le condensateur de conversion entre l'une des pistes électriques de ligne et l'une des pistes électriques de colonne, au moyen du premier interrupteur, puis

- acquérir une tension de résultat de lecture, aux bornes du condensateur de conversion, au moyen du dispositif de mesure de tension, puis

- détermination d'un état résistif de ladite cellule par le module de commande, sur la base de ladite tension de résultat de lecture.

Le condensateur de conversion est donc un condensateur de lecture, permettant d'appliquer à une cellule à lire une tension électrique permettant de lire la cellule, tout en limitant l'énergie électrique susceptible d'être consommée lors de cette lecture. L'état de la cellule mémoire à lire est déterminé à partir de la tension de lecture en question, présente aux bornes du condensateur après qu'il y ait été connecté à cette cellule (en pratique, après qu'il se soit déchargé, en partie, dans cette cellule).

A l'étape b), le condensateur de conversion est déconnecté de la source, et connecté entre la piste électrique de ligne et la piste électrique de colonne en question, au moyen du premier interrupteur, pour réaliser une conversion entre : d'une part, un état résistif de la cellule mémoire qui est située au croisement de ladite piste électrique de ligne et de ladite piste électrique de colonne, et, d'autre part, un niveau de charge du condensateur de conversion. Par niveau de charge, on entend la quantité de charges électriques stockée dans le condensateur de conversion, ou, de manière équivalente, la tension électrique à ses bornes.

Cet agencement, avec ce condensateur de conversion qui joue en quelque sorte un rôle d'intermédiaire entre la source électrique et la matrice, a l'avantage de permettre une conversion bien contrôlée entre les deux grandeurs mentionnées ci-dessus (état résistif d'une part, et niveau de charge de l'autre), avec une limitation naturelle des transferts d'énergie lors de cette conversion puisque l'énergie stockée initialement dans le condensateur est limitée (indépendamment d'éventuels temps de latence dans cette conversion).

Cela permet notamment de mieux contrôler la consommation énergétique associée à une telle conversion (en la limitant à une valeur fixe pré-établie), ainsi que l'énergie qui traverse la cellule mémoire (énergie qui peut source de vieillissement prématuré, ou de stress de la cellule mémoire, si elle est trop élevée).

Comme indiqué plus haut, le condensateur de conversion est employé ici pour réaliser des opérations de lecture. La conversion en question correspond alors à une modification du niveau de charge du condensateur, c'est-à-dire de la tension électrique à ses bornes, en fonction de l'état résistif de la cellule mémoire lue. Dans ce cas, le condensateur est chargé initialement par la source électrique, qui est ensuite déconnectée du condensateur (grâce au deuxième interrupteur). Le condensateur est alors connecté à la matrice (entre l'une des lignes et l'une des colonnes, grâce au premier interrupteur).

Si l'élément mémoire de cette cellule est dans son état hautement résistif, le condensateur de conversion va peu se décharger, et conservera ainsi une tension assez élevée. Au contraire, si l'élément mémoire est dans son état bassement résistif, le condensateur de conversion va se décharger dans la cellule mémoire, et la tension à ses bornes va chuter. La tension finale, aux bornes du condensateur de conversion, renseigne alors sur la donnée stockée dans la cellule mémoire en question.

Et l'énergie électrique consommée lors de cette opération de lecture est constante, limitée (intrinsèquement limitée par l'énergie stockée initialement dans le condensateur de conversion).

En particulier, pour des cellules mémoires de type « 1S1R », l'énergie électrique consommée lors de l'opération de lecture est indépendante de l'instant auquel le sélecteur « 1S » devient conducteur, après la connexion du condensateur (préalablement chargé) à la cellule à lire. Cela est illustré par la figure 2. L'instant $t_o$ est l'instant auquel le condensateur de conversion, préalablement chargé, est connecté aux bornes de la cellule mémoire à lire. Après un certain temps d'incubation, le sélecteur de cette cellule devient conducteur, à l'instant $t_1$. Cela s'accompagne d'une augmentation soudaine du courant $i_1$, délivré par le condensateur et qui se traverse la cellule. Puis ce courant décroit, du fait de la décharge du condensateur.

Si le basculement du sélecteur advient plus tôt, à un instant $t_2$, l'énergie qui sera consommée (et dissipée dans la cellule mémoire) restera la même que celle consommé lors d'un basculement tardif, puisqu'elle est limitée par l'énergie stockée initialement dans le condensateur, et par la décharge de celui-ci.

Le problème de surconsommation mentionné plus haut, dû à la nécessaire prise en compte du phénomène d'incubation (pris en compte via une durée de lecture suffisamment longue) est donc évité grâce à ce condensateur de conversion, employé en quelque sorte comme intermédiaire de lecture de la cellule.

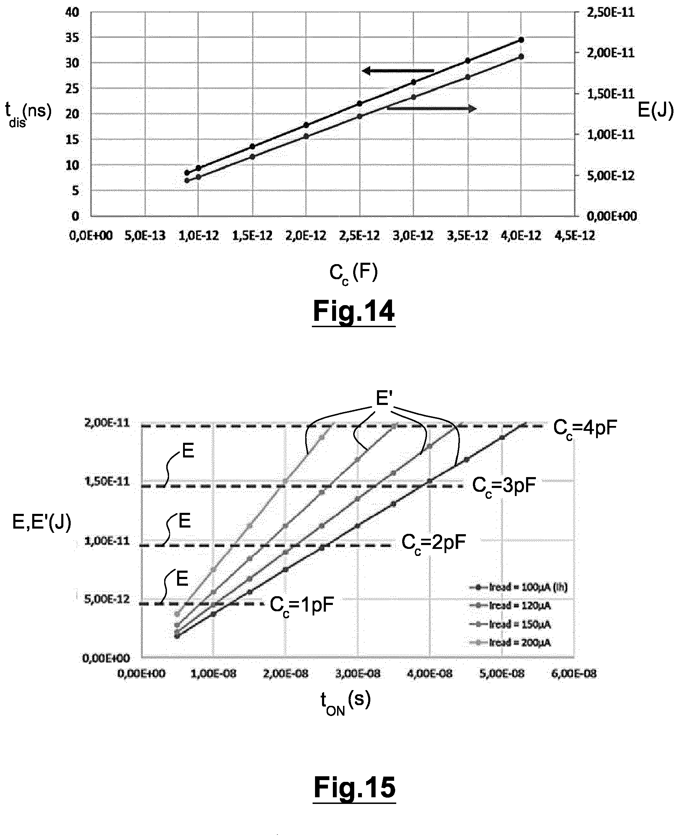

L'énergie électrique consommée lors d'une telle opération de lecture est non seulement indépendante de l'instant de basculement du sélecteur, mais elle peut en outre être rendue inférieure à l'énergie qui serait consommée, en moyenne, avec une lecture sous tension constante, comme le montrera l'exemple de réalisation décrit plus bas, à titre d'illustration, en référence à la figure 15.

Outre les caractéristiques mentionnées ci-dessus, la mémoire qui vient d'être présentée peut présenter une ou plusieurs des caractéristiques optionnelles suivantes, considérées individuellement ou selon toutes les combinaisons techniquement envisageables :

- le dispositif d'interfaçage comprend une résistance additionnelle connectée en série avec le condensateur de conversion ;

- la résistance additionnelle est supérieure à une résistance de ligne de la piste électrique de ligne ou de colonne ;

- le condensateur de conversion a une capacité supérieure à une capacité parasite globale, cette capacité parasite globale étant représentative d'une capacité électrique effective de la partie de la matrice correspondant à ladite piste électrique de ligne et à ladite piste électrique de colonne;

- la capacité du condensateur de conversion est comprise entre deux fois et trente fois la capacité parasite globale ;

- le module de commande configuré pour commander les premier et deuxième interrupteurs de manière à exécuter les étapes a) et b) mentionnées plus haut ;

- le module de commande est configuré pour commander lesdits interrupteurs de manière à ne pas connecter le condensateur de conversion simultanément à ladite source et auxdites pistes électriques de ligne et de colonne ;

- le module de commande est configuré en outre pour:

- à l'étape a), commander le deuxième interrupteur ou la source de manière à charger le condensateur de conversion jusqu'à une tension d'initialisation donnée, puis

- à l'étape b), commander les premier et deuxième interrupteurs de manière à déconnecter la source du condensateur de conversion puis connecter le condensateur de conversion entre ladite piste électrique de ligne et ladite piste électrique de colonne pendant une durée de lecture de cellule mémoire prédéterminée, avant l'acquisition de la tension de résultat de lecture ;

- chaque cellule mémoire comprend un élément mémoire ayant au moins un état hautement résistif et un état bassement résistif, ainsi qu'un sélecteur agencé en série avec l'élément mémoire, le sélecteur étant électriquement conducteur lorsqu'une tension à ses bornes est supérieure à un seuil donné, et étant électriquement isolant sinon ; Par état résistif de la cellule mémoire, on entend alors l'état résistif (hautement résistif ou bassement résistif) de l'élément mémoire de la mémoire ;

- lorsqu'on applique aux bornes de la cellule mémoire une tension comprise entre un seuil de tension bas et un seuil de tension haut :

  - si l'élément mémoire est dans son état bassement résistif, alors, le sélecteur devient électriquement conducteur et la cellule mémoire présente alors une résistance mémoire basse,

  - tandis que si l'élément mémoire est dans son état hautement résistif, alors, le sélecteur reste électriquement isolant et la cellule mémoire présente alors une résistance mémoire haute ;

- ladite tension d'initialisation est supérieure audit seuil de tension bas, multiplié par un coefficient de compensation de répartition de charges ;

- ladite tension d'initialisation est inférieure audit seuil de tension haut, multiplié de ledit coefficient ;

- le coefficient de compensation de répartition de charges est égal à la somme de la capacité du condensateur de conversion et de la capacité parasite globale, divisée par la capacité du condensateur de conversion ;

- la durée de lecture est supérieure à : une résistance effective totale haute, multipliée par la capacité parasite globale, la résistance effective totale haute étant une résistance effective totale dans laquelle se décharge le condensateur de conversion lorsqu'il est connecté à ladite piste électrique de ligne et à ladite piste électrique de colonne, la cellule mémoire, située au croisement de cette ligne et de cette colonne, présentant sa résistance mémoire haute ;

- la durée de lecture est supérieure à la résistance effective totale haute, multipliée ladite capacité parasite globale, et encore multipliée par le logarithme népérien de un plus la capacité du condensateur de conversion divisée par la capacité parasite globale ;

- la résistance effective totale haute est égale à la somme de ladite résistance additionnelle avec l'inverse de la somme de l'inverse d'une résistance de fuite de la matrice avec l'inverse de ladite résistance mémoire haute ;

- le sélecteur est électriquement conducteur à condition en outre qu'un courant électrique qui traverse le sélecteur reste supérieur à courant de maintien;

- la résistance additionnelle est telle qu'une résistance effective totale basse de la mémoire soit inférieure à ladite tension d'initialisation divisée par le courant de maintien du sélecteur, la résistance effective totale basse étant la résistance effective totale dans laquelle se décharge le condensateur de conversion lorsqu'il est connecté à ladite piste électrique de ligne et à ladite piste électrique de colonne, la cellule mémoire, située au croisement de cette ligne et de cette colonne, présentant sa résistance mémoire basse ;

- la résistance additionnelle est telle que la résistance effective totale basse de la mémoire est supérieure à ladite tension d'initialisation divisée par un courant de programmation dudit élément mémoire ;

- la résistance additionnelle est telle que la résistance effective totale basse de la mémoire est, en outre, inférieure audit seuil de tension bas divisée par le courant de maintien du sélecteur ;

- la résistance effective totale basse est égale à la somme de : ladite résistance additionnelle avec l'inverse de la somme de l'inverse de la résistance de fuite de la matrice avec l'inverse de ladite résistance mémoire basse ;

- le condensateur de conversion est situé sur ou sous la matrice de cellules mémoire et s'étend parallèlement à la matrice (à l'aplomb de celle-ci), la matrice et le condensateur de conversion étant superposés l'un à l'autre ;

- le condensateur de conversion occupe une surface inférieure à la surface occupée par la matrice de cellules mémoire ;

- le condensateur de conversion ne déborde pas de la surface occupée par la matrice de cellules mémoire ;

- les éléments mémoire des cellules mémoire sont de type OxRAM (i.e. : réalisés à base d'oxyde conducteur), ou de type CB-RAM, ou de type PCRAM.

Un autre aspect de l'invention concerne un procédé d'interfaçage d'une mémoire telle que décrite ci-dessus, comprenant les étapes suivantes :

- étape a) : connecter le condensateur de conversion à la source au moyen du deuxième interrupteur pour charger le condensateur de conversion, puis

- étape b) :

   - déconnecter le condensateur de conversion de la source, et connecter le condensateur de conversion entre l'une des pistes électriques de ligne et l'une des pistes électriques de colonne, au moyen du premier interrupteur, puis

   - acquérir une tension de résultat de lecture, aux bornes du condensateur de conversion, au moyen du dispositif de mesure de tension, puis

   - détermination d'un état résistif de ladite cellule par le module de commande, sur la base de ladite tension de résultat de lecture.

En particulier, on peut prévoir que, la mémoire comprenant un dispositif de mesure de tension connecté aux bornes du condensateur de conversion :

- à l'étape a), le deuxième interrupteur, ou la source, est commandé de manière à charger le condensateur de conversion jusqu'à une tension d'initialisation donnée,

- à l'étape b), les premier et deuxième interrupteurs sont commandés de manière à déconnecter la source du condensateur conversion, puis de manière à connecter le condensateur de conversion entre ladite piste électrique de ligne et ladite piste électrique de colonne, pendant une durée de lecture de cellule mémoire prédéterminée, avant l'acquisition de la tension de résultat de lecture.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

[Fig. 1] La figure 1 représente schématiquement une impulsion de tension de lecture appliquée à une cellule mémoire résistive pour la lire, ainsi qu'un courant de lecture traversant la cellule, en réponse à cette impulsion.

[Fig. 2] La figure 2 représente schématiquement une impulsion de courant traversant une cellule mémoire lors d'une opération de lecture réalisée au moyen d'un dispositif d'interfaçage mettant en œuvre les enseignements de l'invention.

[Fig. 3] La figure 3 représente schématiquement une mémoire comprenant une matrice de cellules mémoire ainsi que le dispositif d'interfaçage en question.

[Fig. 4] La figure 4 est une vue de détail en perspective, schématique, d'une partie de la matrice de la figure 3.

[Fig. 5] La figure 5 représente schématiquement des caractéristiques courant-tension pour l'une quelconque des cellules mémoires de la matrice de la figure 3.

[Fig. 6] La figure 6 représente schématiquement une répartition de tensions de seuil, pour les cellules de la mémoire de la figure 3.

[Fig. 7] La figure 7 est un schéma électrique équivalent modélisant le comportement électrique d'une partie de la mémoire lors d'une opération de lecture de l'une des cellules.

[Fig. 8] La figure 8 illustre une configuration de polarisation de la matrice dite « V/2 » employée lors d'opérations de lecture.

[Fig. 9] La figure 9 montre l'évolution temporelle de la tension aux bornes d'un condensateur de conversion de la mémoire, lors d'une opération de lecture d'un état résistif haut.

[Fig. 10] La figure 10 montre notamment l'évolution temporelle de la tension aux bornes de la cellule lue, lors de l'opération de lecture correspondant à la figure 9.

[Fig. 11] La figure 11 montre l'évolution temporelle de la tension aux bornes du condensateur de conversion lors d'une opération de lecture d'un état résistif bas.

[Fig. 11B] La figure 11B montre un phénomène d'oscillation qui peut se produire dans certains cas, lors d'une opération de lecture d'un état résistif bas.

[Fig. 12] La figure 12 représente la façon dont varie le rapport entre la surface occupée par la matrice et la surface occupée par le condensateur de conversion, en fonction de la dimension de la matrice.

[Fig. 13] La figure 13 montre comment varie la largeur d'une fenêtre de lecture, en fonction de la capacité du condensateur de conversion.

[Fig. 14] La figure 14 montre comment varie un temps de réponse de la mémoire, intervenant lors d'une opération de lecture, et comment varie l'énergie consommée lors de cette opération, en fonction de la capacité du condensateur de conversion.

[Fig. 15] La figure 15 montre des valeurs d'énergie consommée lors d'une opération de lecture réalisée soit grâce au dispositif d'interfaçage de la figure 3, soit de manière conventionnelle.

## DESCRIPTION DETAILLEE

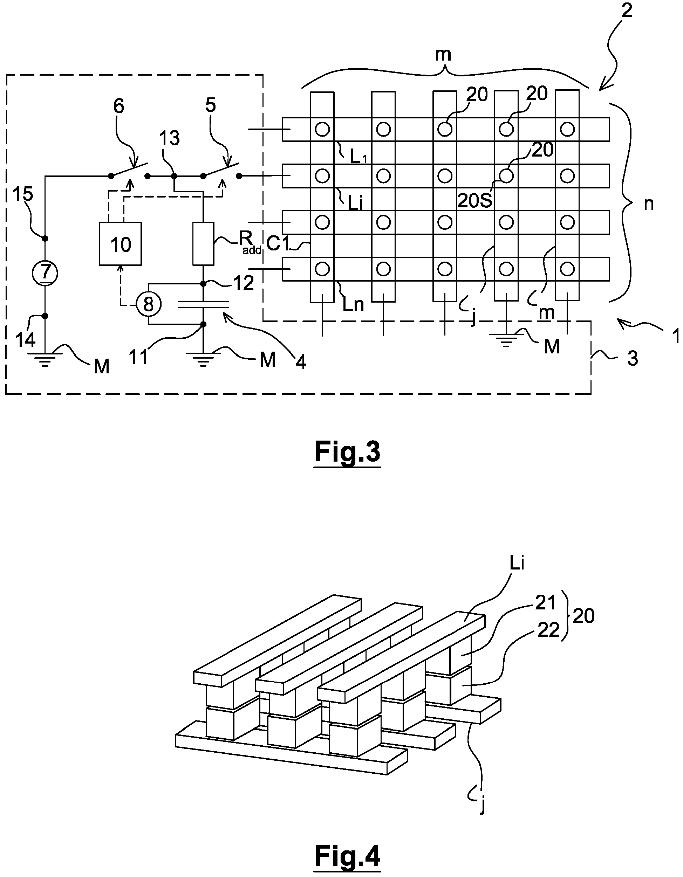

La présente invention concerne notamment une mémoire 1, telle que celle représentée sur la figure 3, qui comprend une matrice 2 de cellules mémoires 20 résistives agencées en n lignes et m colonnes.

La matrice 2 comprend n pistes électriques de ligne $L_1,...,L_i,...,L_n$, et m pistes électriques de colonne $C_1,...,C_i,...,C_m$, par exemple métalliques. Les cellules mémoire 20, au nombre de m×n, sont situées aux croisements entre les pistes électriques de ligne et les pistes électriques de colonne.

Chaque cellule 20 mémoire est connectée entre, d'une part, l'une des pistes électriques de ligne et, d'autre part, l'une des pistes électriques de colonne. Ainsi, pour appliquer une tension électrique V (par exemple une tension de lecture) à l'une des cellules mémoire, située au croisement entre l'une des pistes électriques de lignes, $L_i$, et l'une des pistes électriques de colonne, $C_j$, on applique cette tension électrique entre, d'une part, la piste $L_i$, et d'autre part la piste $C_j$. La cellule en question, située au croisement de ces deux pistes $L_i$ et $C_j$, est repérée par le signe de référence 20S, sur la figure 3. D'un point de vue électrique, tout se passe en quelque sorte comme si une première borne de cette cellule mémoire était connectée à la piste $L_i$, sa deuxième borne étant quant à elle connectée à la piste $C_j$.

La matrice 2, et plus généralement la mémoire 1, peut être réalisée par des techniques planaires, sous la forme d'un empilement de plusieurs couches gravées et fonctionnalisées. Comme représenté sur la figure 4, les pistes électriques de colonne peuvent alors être situées dans une couche inférieure tandis que les pistes électriques de ligne sont situées dans une couche supérieure (ou inversement), les cellules mémoires 20 (appelées aussi points mémoire) s'étendant alors entre cette couche inférieure et cette couche supérieure. Ce type de matrice est souvent appelée matrice de type « crossbar », dans ce domaine technique.

Chaque cellule mémoire 20 comprend un élément mémoire 22 dont la résistance peut être ajustée électriquement :

- soit à un niveau de résistance bas, lors d'une opération d'écriture généralement appelée « SET »,

- soit à un niveau de résistance haut, lors d'une autre opération d'écriture généralement appelée « RESET » (parfois considéré comme une opération de remise à zéro).

Dans son état bassement résistif, l'élément résistif 20 a une résistance électrique basse notée $R_{SET}^{RRAM}$, et dans son état hautement résistif, il a une résistance électrique haute notée $R_{RESET}^{RRAM}$. Les opérations d'écriture en question sont parfois appelées opérations de programmation, dans ce domaine technique.

Une donnée peut être écrite et stockée dans chaque cellule mémoire 20, cette donnée étant représentée par le niveau de résistance de l'élément mémoire 22. Ici, les données en question sont des données binaires, et les cellules mémoires sont programmées de manière à placer leurs éléments mémoire 22 respectifs soit dans leur état hautement résistif, soit dans leur état bassement résistif.

Toutefois, en variante, on pourrait exploiter plus de deux niveaux de résistance distincts, pour chaque élément mémoire (éléments « multiniveaux »), de manière à stocker dans chaque cellule une donnée susceptible de prendre plus de deux valeurs différentes. La présente technologie, basée notamment sur un condensateur de conversion spécifique, est présentée ci-dessous dans le cas d'éléments mémoire à deux niveaux mais elle peut s'appliquer aussi à des cellules mémoires multiniveaux telles que mentionnées ci-dessus.

Ici, les cellules mémoire 20 sont du type « 1S1R », c'est-à-dire qu'elles comportent, en plus de l'élément mémoire 22, un sélecteur 21 agencé en série avec l'élément mémoire 22 (figure 4). D'un point de vue électrique, le sélecteur 21 et l'élément mémoire sont connectés en série, l'un à la suite de l'autre, entre les deux pistes $L_i$, $C_j$ correspondantes. Les sélecteurs 21 peuvent être réalisés dans une partie dite « backend » de la puce électronique comprenant la mémoire 1.

Différentes technologies sont envisageables, pour réaliser le sélecteur 21. Il peut s'agir par exemple d'un sélecteur de type MIEC, selon l'acronyme anglo-saxon de « Mixed Ionic Electronic Conduction », de type MIT (« metal-insulator transition switch ») ou encore de type OTS (pour « Ovonic Threshold Switch », soit commutateur ovonique à seuil) qui sont des commutateurs à seuil réalisé à partir de films en alliages amorphes de chalcogénures, un tel alliage étant composé d'un élément chalcogène non oxygène (S, Se, Te), en alliage avec des éléments comme Ge, Si, Sb, As, Al, Zn, Ga. Ils peuvent être dopés avec des éléments légers comme B, C, N, O, P (avec des concentrations en dopant qui peuvent être supérieures à 1% atomique).

Ici, les sélecteurs 21 sont de type OTS.

Le sélecteur 21 devient électriquement conducteur lorsque la tension à ses bornes devient supérieure à une tension seuil de sélecteur $V_{th}^{Sel}$, et qui est électriquement isolant sinon. Par électriquement conducteur, on entend qu'il présente alors une résistance électrique $R_{ON}^{Sel}$ faible, par exemple inférieure à 30 kiloohms, voir inférieure à 3 kiloohms. Lorsque la tension à ses bornes est inférieure à la tension seuil en question, la résistance électrique du sélecteur est nettement plus élevée, par exemple dans un facteur $10^4$, ou $10^5$ (et elle varie en fonction de la tension, en général), et le sélecteur est électriquement isolant. Par électriquement isolant, on entend qu'il présente une résistance électrique élevée, par exemple supérieure à 1 mégohm, voire à 3 mégohms. Le sélecteur, lorsqu'il est électriquement conducteur, il peut en particulier présenter une résistance inférieure à la résistance électrique basse $R_{SET}^{RRAM}$ de l'élément mémoire 22, tandis que quand il est électriquement isolant, il peut présenter une résistance supérieure à la résistance électrique haute $R_{RESET}^{RRAM}$ de cet élément.

Pour le type de sélecteur considéré ici (OTS), le sélecteur 21 est électriquement conducteur lorsque la tension à ses bornes est supérieure à la tension seuil de sélecteur $V_{th}^{Sel}$, et à condition en outre que le courant i qui traverse le sélecteur reste supérieur à un courant de maintien $I_h$.

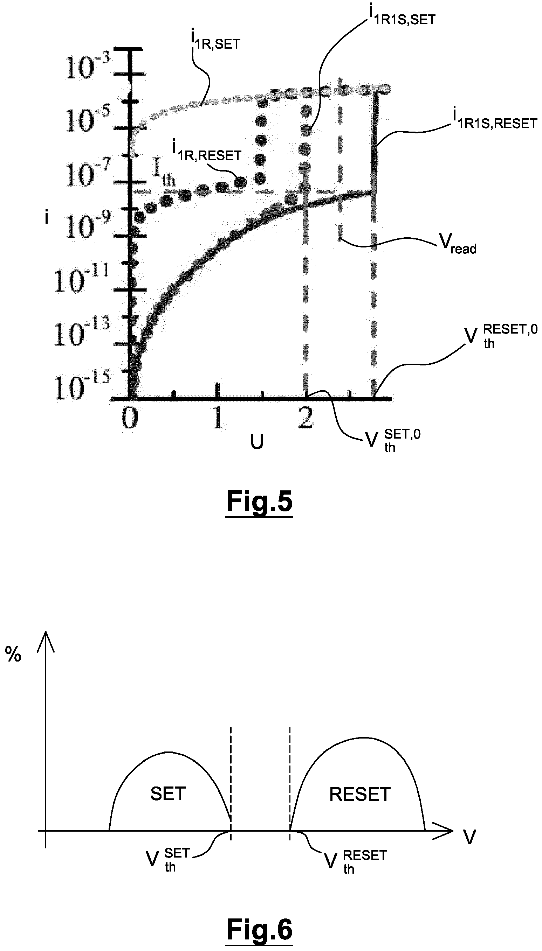

La figure 5 montre des caractéristiques courant-tension pour l'élément mémoire 22 seul, et pour la cellule mémoire 20 complète (élément mémoire 22 + sélecteur 21). En l'occurrence, l'élément mémoire 22 est du type OxRAM, ici.

Sur cette figure, on a représenté le courant électrique i qui traverse l'élément considéré (exprimé en unités arbitraires) en fonction de la tension U appliquée à ses bornes (également en unités arbitraires). Les points de mesure $i_{1R,SET}$ et $i_{1R,RESET}$ correspondent à l'élément mémoire 22 seul, respectivement dans son état bassement résistif et dans son état hautement résistif. Les points de mesure $i_{1R1S,SET}$ et $i_{1R1S,RESET}$ correspondent quant à eux à l'ensemble de la cellule mémoire, lorsque l'élément mémoire 22 est, respectivement, dans son état bassement résistif et dans son état hautement résistif.

Lorsque l'élément mémoire 22 est dans son état bassement résistif et que le sélecteur 21 n'a pas encore basculé dans son état conducteur, la résistance de l'élément mémoire, $R_{SET}^{RRAM}$ (par exemple de l'ordre de la dizaine de kilohms) est nettement plus petite que celle du sélecteur (la résistance du sélecteur, juste en dessous de la tension seuil de sélecteur $V_{th}^{Sel}$, est typiquement de l'ordre du mégohm). L'essentiel de la tension U appliquée à la cellule mémoire 20 se retrouve donc aux bornes du sélecteur 21 (la tension U se distribue principalement aux bornes du sélecteur). Ainsi, lorsque cette tension devient supérieure à la tension seuil de sélecteur $V_{th}^{Sel}$, la résistance d'ensemble de la cellule mémoire bascule et la cellule présente ensuite une résistance mémoire basse $R_{cell}^{ON} = R_{SET}^{RRAM} + R_{ON}^{sel}$. Sur la figure 5, le seuil de tension bas $V_{th}^{SET,o}$ est donc égal, ou tout au moins proche de la tension seuil de sélecteur $V_{th}^{Sel}$.

Lorsque l'élément mémoire 22 est dans son état hautement résistif, sa résistance $R_{RESET}^{RRAM}$ est plus proche de la résistance du sélecteur 21 juste avant basculement. Le tension U appliquée à la cellule mémoire se répartit alors entre le sélecteur et l'élément mémoire, si bien qu'une tension U à peine supérieure à $V_{th}^{Sel}$ ne suffit plus pour faire basculer le sélecteur dans son état conducteur. En pratique, tant que la tension U est inférieure à un seuil de tension haut $V_{th}^{RESET,o}$, le sélecteur reste alors bloqué. Au-dessus de $V_{th}^{RESET,o}$, non seulement le sélecteur bascule dans son état conducteur, mais, en plus, l'élément mémoire est en quelque-sorte réécrit, passant dans son état bassement résistif (alors qu'il était initialement dans son état hautement résistif). Lorsque la tension U reste inférieure à $V_{th}^{RESET,o}$, la cellule mémoire présente une résistance mémoire haute $R_{cell}^{OFF}$, égale à la somme de la résistance électrique $R_{RESET}^{RRAM}$ de l'élément mémoire 22 dans son état hautement résistif, et d'une résistance du sélecteur 21 à l'état bloqué (qui, dans ces conditions, peut s'exprimer comme U/$I_{th}$, où $I_{th}$ est le courant « de seuil » qui traverse le sélecteur pour une tension juste inférieure au seuil $V_{th}^{Sel}$).

Quoiqu'il en soit, pour la cellule mémoire 20 complète, lorsque la tension U est comprise entre le seuil de tension bas $V_{th}^{SET,o}$, et le seuil de tension haut $V_{th}^{RESET,o}$, elle présente une résistance qui est soit $R_{cell}^{ON}$, soit $R_{cell}^{OFF}$, selon l'état bassement ou hautement résistif de l'élément mémoire, et qui est donc représentative de la donnée (0 ou 1) stockée dans la cellule mémoire. Une tension comprise dans cette gamme permet ainsi une lecture de cette donnée, sans risquer de réécrire la cellule lors de cette lecture (ou tout au moins avec un risque de réécriture, ou, autrement dit, d'effacement, faible).

Les différentes cellules mémoires 20 de la matrice peuvent, du point de vue de leurs caractéristiques de fonctionnement (seuils de tension, niveaux de résistance, ...), présenter une certaine disparité les unes par rapport aux autres, que ce soit juste après la fabrication et mise en service de la mémoire, ou plus tard, du fait d'un vieillissement différent entre cellules. Quoiqu'il en soit, lors du pilotage de la mémoire 1, il est souhaitable de tenir compte de cette disparité.

La figure 6 représente schématiquement la façon dont sont distribués le seuil de tension bas, et le seuil de tension haut parmi les différentes cellules de la matrice 2. Sur cette figure, les tensions sont représentées en abscisses, tandis que la proportion de cellules ayant un seuil de tension bas, ou haut donné, est représenté en ordonnées, en correspondance avec la valeur de tension en question.

Sur cette figure, dans la distribution de seuils de tension bas, le plus grand de ces seuils est repéré par la référence $V_{th}^{SET}$. Dans toute la suite, l'expression « seuil de tension bas » désigne d'ailleurs la quantité $V_{th}^{SET}$. De manière comparable, dans la distribution de seuils de tension hauts, le plus petit de ces seuils est repéré par la référence $V_{th}^{RESET}$, et, dans toute la suite, l'expression « seuil de tension haut » désigne la quantité $V_{th}^{RESET}$.

Compte tenu de cette distribution, une tension de lecture comprise entre $V_{th}^{SET}$ et $V_{th}^{RESET}$ permet clairement de lire l'une quelconque des cellules mémoire de la matrice sans risquer de la réécrire (ou tout au moins avec un risque de réécriture faible).

Quoiqu'il en soit, quel que soit le type de sélecteur employé, chaque cellule mémoire 20 est telle que, ici, lorsqu'on applique aux bornes de cellule une tension comprise entre :

- une tension de seuil basse, en l'occurrence le seuil de tension bas $V_{th}^{SET}$, et

- une tension de seuil haute, en l'occurrence le seuil de tension haut $V_{th}^{RESET}$, alors :

- l'état, hautement résistif ou bassement résistif de l'élément résistif 22 n'est pas modifié, et

- la cellule mémoire 20 présente soit sa résistance mémoire haute $R_{cell}^{OFF}$, soit sa résistance mémoire basse $R_{cell}^{ON}$, selon l'état, hautement résistif ou bassement résistif de l'élément résistif 22.

La mémoire 1 comprend, en plus de la matrice 2, un dispositif d'interfaçage 3 pour interfacer ladite matrice 2.

Le dispositif d'interfaçage 3 permet ici d'adresser telle ou telle cellule mémoire de la matrice, c'est-à-dire de la connecter électriquement (par un système d'interrupteurs) à un circuit électrique de pilotage de la cellule, pour interagir avec elle.

Plus particulièrement, le dispositif d'interfaçage 3 comprend au moins (figure 3) :

- un condensateur de conversion 4,

- un premier interrupteur 5, agencé dans le dispositif d'interfaçage pour, sur commande :

  - soit connecter le condensateur de conversion 4 entre l'une des pistes électriques de ligne Li et l'une des pistes électriques de colonne C$_j$ de la matrice 2,

  - soit déconnecter le condensateur de conversion desdites pistes électriques L$_i$, C$_j$,

- une source électrique, 7, et

- un deuxième interrupteur 6 agencé dans le dispositif d'interfaçage pour, sur commande :

  - soit connecter la source électrique aux bornes du condensateur de conversion,

  - soit déconnecter la source 7 du condensateur de conversion 4.

Les interrupteurs 5 et 6 sont par exemple des transistors. La source 7 est apte à charger le condensateur de conversion 4. Il s'agit ici d'une source de tension (réalisé par exemple sous la forme d'un régulateur de tension, lui-même alimenté électriquement). En variante, il pourrait s'agir d'une source de courant, ou d'une source quelconque pouvant délivrer un courant et une tension arbitraires. Le premier interrupteur 5 est connecté entre le condensateur de conversion 4 et l'une des pistes électriques de ligne, ou l'une des pistes électriques de colonne de la matrice. Le deuxième interrupteur 6 est connecté entre le condensateur de conversion et la source 7.

Le condensateur de conversion 4 permet une conversion entre :

- d'une part, un état résistif de la cellule mémoire 20S à laquelle est connecté le condensateur de conversion 4, et

- d'autre part, un état de charge du condensateur, traduit par une tension aux bornes du condensateur.

Cet agencement, avec ce condensateur de conversion 4 qui joue en quelque sorte un rôle d'intermédiaire entre la source 7 et la matrice 2, a l'avantage de permettre une conversion bien contrôlée entre les deux grandeurs mentionnées ci-dessus (état résistif d'une part, et état de charge de l'autre), avec une limitation naturelle des transferts d'énergie lors de cette conversion puisque l'énergie stockée initialement dans le condensateur est limitée (le condensateur ayant une capacité électrique limitée).

Cela permet notamment de mieux contrôler la consommation énergétique associée à une telle conversion (en la limitant à une valeur fixe préétablie), ainsi que l'énergie qui traverse la cellule mémoire (énergie qui peut être source de vieillissement prématuré, ou de stress de la cellule mémoire, si elle est trop élevée).

D'ailleurs, tel que représenté, le dispositif d'interfaçage 3 comprend un module de commande 10 agencé pour commander les premier et deuxième interrupteurs 5, 6, le module de commande étant configuré pour commander ces interrupteurs de manière à ne pas connecter le condensateur de conversion 4 simultanément à la source 7 et auxdites pistes électriques de ligne et de colonne $L_i$, $C_j$, justement pour que le condensateur de conversion 4 joue pleinement son rôle d'intermédiaire entre la source 7, et la cellule 20S adressée par le dispositif d'interfaçage 3.

Le module de commande 10 est réalisé par exemple sous la forme d'un circuit électrique, par exemple un circuit électrique programmable, qui délivre des signaux de commande des interrupteurs, selon une séquence temporelle prédéterminée. Le module de commande 10 est par exemple intégré sur la même puce électronique que la matrice, de même que les autres composants du module d'interfaçage 3.

Comme on peut le voir sur la figure 3, le dispositif d'interfaçage 3 comprend aussi une résistance additionnelle $R_{add}$, ici. Cette résistance est connectée en série avec le condensateur de conversion 4, entre ce condensateur et la piste électrique de ligne $L_i$ (en variante, elle pourrait être connectée entre le condensateur de conversion et la piste électrique de colonne $C_j$, par exemple).

Cette résistance additionnelle permet notamment, par le choix de sa valeur, de limiter le courant électrique maximal débité par le condensateur de conversion dans la matrice, ce qui permet de contrôler encore mieux les échanges électriques, lors du pilotage de la matrice. La résistance additionnelle est notamment supérieure à la résistance de ligne de la piste électrique de ligne ou de colonne $L_i$, $C_j$. La résistance additionnelle $R_{add}$ est réalisée ici sous la forme d'un composant électrique dédié (en matériau résistif). En variante, cette résistance pourrait toutefois être la résistance interne (résistance effective) du premier interrupteur 5 dans son état passant.

La structure du dispositif d'interfaçage 3, tel qu'il est représenté sur la figure 3, est décrite maintenant plus en détail.

Une première borne 11 du condensateur de conversion 4 est connectée à la piste électrique de colonne $C_j$, par l'intermédiaire d'une masse électrique M. La piste électrique de colonne $C_j$ est reliée électriquement à la masse M, et la première borne 11 du condensateur de conversion est elle aussi reliée électriquement à cette masse électrique.

Une deuxième borne 12 du condensateur de conversion 4 est connectée à la piste électrique de ligne $L_i$, par l'intermédiaire de la résistance additionnelle $R_{add}$ et du premier interrupteur 5. En l'occurrence, la résistance additionnelle $R_{add}$ est reliée électriquement entre, d'une part, la deuxième borne 12 du condensateur, et, d'autre part, une borne intermédiaire 13. Le premier interrupteur est relié électriquement entre cette borne intermédiaire 13 d'une part et la piste électrique de ligne $L_i$ d'autre part.

Une première borne 14 de la source 7 est connectée à la masse M, tandis qu'une deuxième borne 15 de cette source est connectée à la borne intermédiaire 13, par l'intermédiaire du deuxième interrupteur 6 (le deuxième interrupteur 6 est connecté entre la deuxième borne 15 de la source d'une part, et la borne intermédiaire 13 d'autre part).

Le dispositif d'interfaçage 3 comprend aussi un dispositif de mesure de tension 8, connecté entre les première et deuxième bornes 11, 12 du condensateur de conversion 4. Ce dispositif est apte à mesurer la tension aux bornes du condensateur de conversion 4, ou, tout au moins, apte à la comparer un seuil prédéterminé donné. Il est relié au module de commande 10 et est apte à lui communiquer le résultat de cette mesure de tension, ou de cette comparaison.

Comme l'homme du métier pourra s'en rendre compte, différentes variantes, compatibles avec la fonction du condensateur de conversion 4 mentionnée plus haut, peuvent être apportées au dispositif de conversion 3. Ainsi, les rôles des pistes électriques de ligne et de colonne $L_i$ et $C_j$ pourraient être inversés par exemple (la piste électrique de colonne étant alors reliée au condensateur de conversion par le premier interrupteur, tandis que la piste électrique de ligne serait alors reliée à la masse M). On pourrait aussi prévoir de connecter le deuxième interrupteur 6 entre la deuxième borne 15 de la source 7 et la deuxième borne 12 du condensateur, par exemple, plutôt que de le connecter entre la deuxième borne 15 de la source 7 et la borne intermédiaire 13.

Le dispositif d'interfaçage 3 peut notamment être employé, comme ici, pour effectuer des opérations de lecture des cellules mémoires de la matrice.

Pour cela, le module de commande 10 est configuré (par exemple programmé) pour exécuter les opérations suivantes :

- commander les premier et deuxièmes interrupteurs 5, 6 pour connecter la source 7 au condensateur de conversion 4, le condensateur de conversion étant alors déconnecté des pistes électriques de ligne et de colonne $L_i$ et $C_j$ (l'une de ses deux bornes pouvant toutefois rester connecter à l'une de ces pistes), de manière à charger le condensateur de conversion à une tension d'initialisation $V^{init}$ donnée, puis

- commander les premier et deuxième interrupteurs 5, 6 pour déconnecter la source 7 du condensateur de conversion 4 et connecter le condensateur de conversion entre la piste électrique de ligne $L_i$ et la piste électrique de colonne $C_j$, le condensateur de conversion restant ensuite connecté entre ces deux pistes électriques pendant une durée de lecture de cellule mémoire, $t_{meas}$, prédéterminée, puis

- acquérir une tension de résultat de lecture $V_R$, aux bornes du condensateur de conversion 4, au moyen du dispositif de mesure de tension 8.

La tension de résultat de lecture, acquise par le dispositif de mesure de tension 8 peut être mesurée par le dispositif de mesure de tension 8 (qui délivre alors une valeur, par exemple sous la forme de données logiques, numériques), ou plus simplement comparée à un seuil donné (ce qui constitue une forme simplifiée de mesure), le résultat prenant alors la forme d'un signal électrique haut, ou bas, selon le résultat de la comparaison, par exemple.

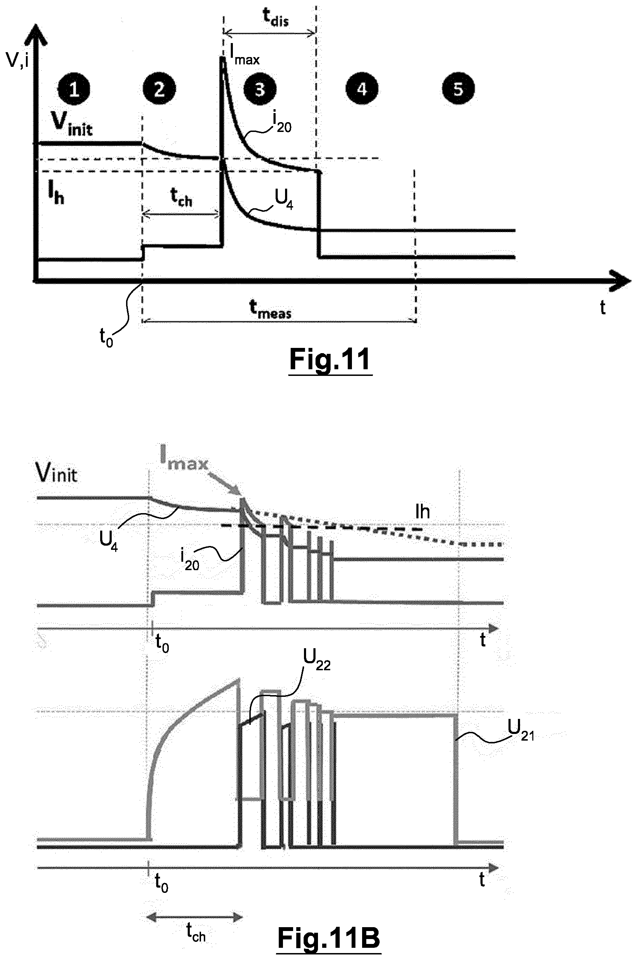

Si l'élément mémoire 22 de la cellule mémoire sélectionnée 20S (située au croisement de $L_i$ et $C_j$) est dans son état hautement résistif, le sélecteur ne basculera pas dans son état conducteur, et le condensateur de conversion 4 se déchargera très peu au cours de la durée de lecture $t_{meas}$, conservant ainsi une tension élevée. Au contraire, si l'élément mémoire est dans son état bassement résistif, le sélecteur basculera dans son état conducteur, et le condensateur de conversion 4 se déchargera dans la résistance mémoire basse $R_{cell}^{ON}$, la tension à ses bornes chutant alors notablement (figure 11). La tension de résultat de lecture $V_R$, mesurée finalement aux bornes du condensateur de conversion 4, renseigne donc sur la donnée (0 ou 1) stockée dans la cellule mémoire en question.

Et, comme expliqué dans la partie intitulée « Résumé », l'énergie électrique consommée lors de cette opération de lecture est intrinsèquement limitée, indépendamment de l'instant auquel le sélecteur bascule dans son état conducteur. Cela permet notamment de s'affranchir des problèmes dus au phénomène d'incubation mentionné plus haut.

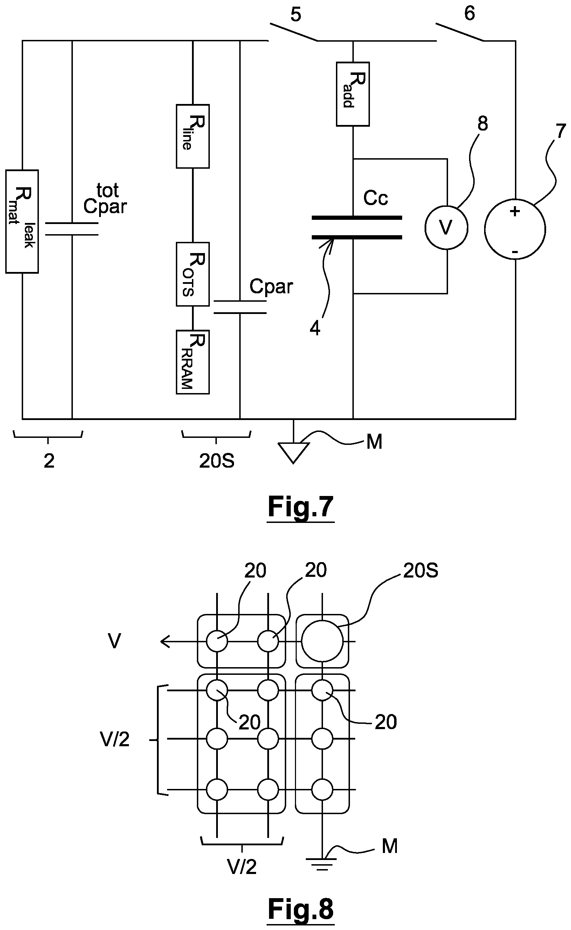

Dans la suite, on présentera des caractéristiques de fonctionnement (temps de réponse, valeurs de tension,...), attendues pour le dispositif d'interfaçage 3 lors d'une telle opération de lecture, dans le cadre d'une modélisation légèrement simplifiée de ce fonctionnement correspondant au schéma électrique équivalent de la figure 7.

On présentera ensuite des critères de dimensionnement des composants du dispositif d'interfaçage (capacité $C_c$ du condensateur de conversion 4, valeur de la résistance additionnelle $R_{add}$, ...) qui, compte tenu des caractéristiques de fonctionnement en question, sont bien adaptés pour cette opération de lecture.

Un exemple numérique de réalisation sera présenté ensuite, ainsi qu'une illustration de l'influence de la valeur de la capacité $C_c$ sur les performances de la mémoire et l'encombrement du dispositif.

Modélisation

La figure 7 représente un schéma électrique équivalent de la mémoire 1, lors d'une opération de lecture de la cellule mémoire 20S. En plus des composants (4 à 8) du dispositif d'interfaçage 3, présentés plus haut, on voit sur cette figure un modèle représentant de manière simplifiée le comportement électrique de la cellule mémoire 20S lue, et celui du reste de la matrice 2.

La cellule mémoire est modélisée par :

- un ensemble de trois résistances $R_{line}$, $R_{OTS}$ et $R_{RRAM}$ connectées en série les unes aux autres, cet ensemble étant connecté entre la masse M et le premier interrupteur 5, et

- un condensateur ayant une capacité parasite $C_{par}$, connecté en parallèle de cet ensemble de résistances.

La résistance $R_{line}$ est la résistance électrique des pistes électriques $L_i$ et $C_j$. En pratique, elle est nettement plus petite que $R_{OTS}$ et $R_{RRAM}$ qui sont, respectivement, la résistance du sélecteur 21 et la résistance de l'élément mémoire 22.

Le reste de la matrice est représentée par une résistance de fuite de la matrice, $R_{mat}^{leak}$, et une capacité parasite globale $C_{par}^{tot}$ connectée en parallèle de la résistance de fuite, l'ensemble étant connecté entre la masse M et le premier interrupteur 5.

La capacité parasite globale $C_{par}^{tot}$ est représentative d'une capacité électrique effective de la partie de la matrice 2 qui comprend la ligne et la colonne de cellules mémoires 20 correspondant à la piste électrique de ligne $L_i$ et à la piste électrique de colonne $C_j$, sans la cellule mémoire 20S (située au croisement de cette ligne et de cette colonne). Il s'agit donc de la capacité parasite effective des (m+n-1) cellules mémoires en question.

Il faut tenir compte de la capacité de ces cellules, pour déterminer le comportement électrique de la mémoire (par exemple les temps de réponse), même si ces cellules ne sont pas lues, lors de l'opération de lecture en question. En effet, lors de la lecture de telle ou telle cellule de la matrice, les autres cellules sont elles aussi polarisées (pour ne pas les laisser à un potentiel flottant), mais de manière à leur appliquer une tension qui reste inférieure à la tension de lecture (pour ne pas faire basculer leurs sélecteurs à l'état conducteur). Une configuration de polarisation de la matrice dite « V/2 » est représentée schématiquement sur la figure 8. On voit bien que, dans cette configuration, les (m+n-2) cellules de la ligne $L_i$

**EP 4 016 531 B1**

et de la colonne $C_j$, autres que la cellule 20S visée, sont polarisées sous une tension V/2, alors que la cellule 20S est polarisée sous une tension V. Et comme ces (m+n-2) cellules sont polarisées, alimentées, il faut tenir compte de leur capacité pour déterminer la réponse électrique (en particulier le temps de réponse) de l'ensemble.

En l'occurrence, pour cette configuration de polarisation, la capacité parasite globale $C_{par}^{tot}$ peut être évaluée comme étant égale à (m+n-1)×$C_{par}$. On notera que m+n-1 est le nombre total de cellules (y compris la cellule 20S) que comprend la ligne $L_i$ et la colonne $C_j$. Pour d'autres configurations de polarisation (par exemple la configuration appelée « V/3 » dans la littérature), l'expression de $C_{par}^{tot}$ peut toutefois être différente.

Pour ce qui est de la résistance de fuite $R_{mat}^{leak}$, on considère ici qu'elle est donnée par la relation suivante :

$$R_{mat}^{leak} = \left[ \left( \frac{I_{leak}}{Vleak} + \frac{1}{Rline} + \frac{1}{R_{RESET}^{RRAM}} \right) \times (m + n - 2) \right]^{-1}$$

où $I_{leak}$ est un courant de fuite d'une cellule de la matrice soumise à la tension $V_{leak}$ (par exemple V/2).

Par ailleurs, dans ce modèle, on néglige :

- la capacité parasite de la circuiterie externe à la matrice,

- l'influence du courant sur la résistance du sélecteur (appelée aussi OTS dans la suite) dans son état passant (conducteur) ; cette résistance, $R_{ON}^{sel}$, est supposée constante,

- l'influence de l'évolution des tensions (lors de la décharge du condensateur de conversion) sur les courants de fuite ; des courants constants et maximum sont considérés (cas le plus défavorable).

On suppose par ailleurs :

- comme déjà indiqué, une configuration de polarisation de la matrice de type « V/2 »,

- que les courants de fuite ne proviennent que des (m+n-1) cellules partiellement sélectionnées,

- qu'une seule cellule mémoire est lue à la fois.

Caractéristiques de fonctionnement

Dans ce contexte, on a déterminé, pour l'opération de lecture décrite plus haut, l'évolution au cours du temps t :

- de la tension $U_4$ aux bornes du condensateur de conversion 4,

- de la tension $U^{SET}_{20}$ et $U^{RESET}_{20}$ aux bornes de la cellule mémoire 20S, et

- du courant $i_{20}$ qui traverser la cellule 20S.

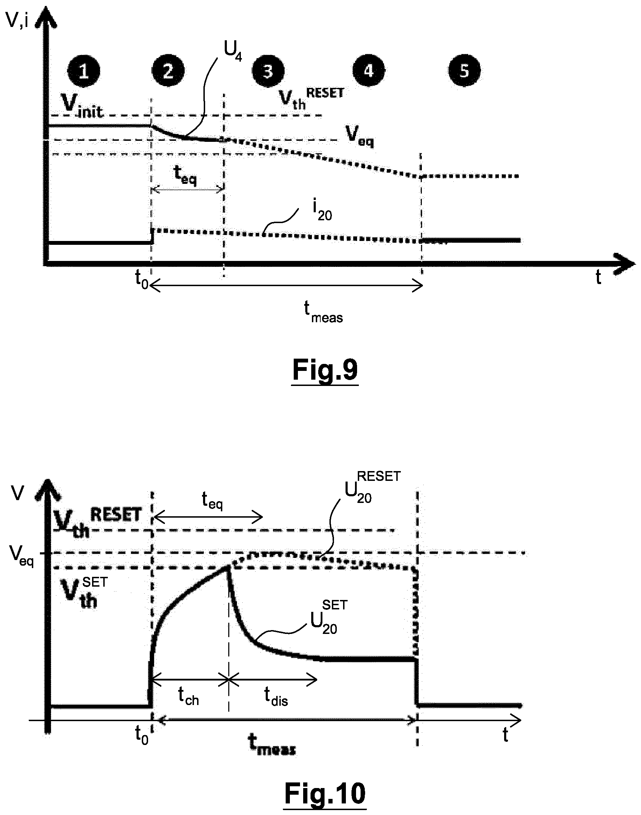

L'évolution temporelle de ces quantités est représentée schématiquement sur les figures 9 à 11.
Sur la figure 9, on peut voir l'évolution au cours du temps t de la tension $U_4$ lorsque l'élément mémoire de la cellule 20S est dans son état hautement résistif (RESET).
Le condensateur de conversion 4 a été préalablement chargé, à une tension initiale $V_{init}$, par la source 7. La source est ensuite déconnectée (grâce au deuxième interrupteur 6). Puis, à l'instant $t_o$, à la fin d'une première phase (phase « 1 », sur les figures), on connecte le condensateur de conversion 4 à la matrice en fermant le premier interrupteur 5.
La charge électrique contenue initialement dans le condensateur de conversion 4 se répartit alors entre ce condensateur et les capacités parasites mentionnées plus haut. Pendant cette deuxième phase (phase « 2 » sur les figures), la tension $U^{RESET}_{20}$ aux bornes de la cellule mémoire 20S augmente progressivement (figure 10) tandis que la tension $U_4$ diminue, ces deux tensions atteignant finalement une même tension d'équilibre $V_{eq}$.
Cette tension d'équilibre $V_{eq}$, fixée par la répartition de charge en question, s'exprime donc comme :

$$V_{eq} = V_{init} \frac{1}{1 + C_{par}^{tot}/C_c}$$

La durée $t_{eq}$ pour atteindre cette tension d'équilibre s'exprime comme :

$$t_{eq} = -\ln\left(1 - V_{eq}/V_{init}\right) \times R_{tot}^{OFF}.C_{par}^{tot}$$

où $R_{tot}^{OFF}$ est une résistance effective totale haute dans laquelle se décharge le condensateur de conversion 4.

La résistance $R_{tot}^{OFF}$ s'exprime donc ici comme :

$$R_{tot}^{OFF} = (1/(1/R_{leak}^{mat} + 1/R'_{cell}^{OFF})) + R_{add}$$

où $R'_{cell}^{OFF}$ est la somme de la résistance mémoire haute $R_{cell}^{Off}$ de la cellule et de la résistance de ligne $R_{line}$ (cette dernière étant généralement négligeable, en pratique).

Elle peut s'exprimer comme :

$$R_{cell}^{OFF} = \frac{V_{init}}{I_{th}} + R_{RESET}^{RRAM} + R_{line}$$

où $V_{init}/I_{th}$ est une estimation de la résistance du sélecteur 21, dans son état bloqué, dans ces conditions de fonctionnement.

Ensuite, pendant une troisième phase (phases « 3 » et « 4 » sur la figure 9), la tension aux bornes du condensateur de conversion 4 décroit progressivement (ainsi que celle, $U^{RESET}_{20}$, aux bornes de la cellule 20S), du fait des fuites de courant mentionnées plus haut.

A l'issue du temps de mesure $t_{meas}$, la tension de résultat de lecture $V_R$ est alors égale à une tension $V_{read}^{RESET}$, qui, en supposant que $t_{meas}$ est supérieur à $t_{eq}$, peut s'exprimer comme :

$$V_{read}^{RESET} = V_{eq} \times \left(1 - exp\left[-t_{meas}/\tau_{off}\right]\right)$$

où $\tau_{off} = R_{tot}^{OFF} \times \left(C_c + C_{par}^{tot}\right)$ est le temps de réponse du circuit RC équivalent à la mémoire, dans cette situation.

Sur la figure 11, on peut voir l'évolution au cours du temps t de la tension $U_4$ lorsque l'élément mémoire de la cellule 20S est dans son état bassement résistif (SET).

Le condensateur de conversion 4 est préalablement chargé à la tension initiale $V_{init}$, comme décrit plus haut, lors de la première phase (phase « 1 », sur les figures). A l'instant $t_0$, à la fin de la première phase, on connecte le condensateur de conversion 4 à la matrice en fermant le premier interrupteur 5.

Comme dans le cas d'un élément mémoire hautement résistif, la charge électrique contenue initialement dans le condensateur de conversion 4 commence par se répartir alors entre ce condensateur et les capacités parasites au cours d'une deuxième phase (phase « 2 » sur les figures), la tension $U^{SET}_{20}$ aux bornes de la cellule mémoire 20S augmentant progressivement en tendant vers la tension d'équilibre $V_{eq}$. (figure 10).

Mais, comme l'élément résistif 22 est dans son état bassement résistif, lorsque la tension $U^{SET}_{20}$ atteint le seuil de tension bas $V_{th}^{SET}$, le sélecteur 21 bascule dans son état conducteur, initiant ainsi une troisième phase, « 3 », de décharge rapide du condensateur de conversion.

La durée $t_{ch}$ de la deuxième phase s'exprime comme :

$$t_{ch} = -\ln(1 - V_{th}^{SET}/V_{init}) \times R_{tot}^{OFF}.C_{par}^{tot}$$

Au cours de la <u>troisième phase</u>, le condensateur de conversion 4 se décharge rapidement dans la cellule mémoire 20S, qui présente la résistance mémoire basse $R_{cell}^{ON}$. Cette décharge perdure tant que le courant $i_{20}$ qui traverse la cellule reste supérieur au courant de maintien $I_h$. Lorsque $i_{20}$ devient inférieur ou égal à $I_h$, le sélecteur rebascule dans son état bloqué et le courant $i_{20}$ s'en trouve fortement réduit, ce qui marque la fin de la troisième phase.

La valeur maximale $I_{max}$ atteinte par le courant $i_{20}$, au début de la troisième phase (i.e.: juste après le basculement du sélecteur dans son état conducteur), peut s'exprimer comme $I_{max} = V_{init}/R_{tot}^{ON}$, où $R_{tot}^{ON}$ est une résistance effective totale basse dans laquelle se décharge le condensateur de conversion 4.

La résistance $R_{tot}^{ON}$ peut s'exprimer comme

$$R_{tot}^{ON} = 1/(1/R_{leak}^{mat} + 1/R'_{cell}^{ON}) + R_{add}$$

où $R'_{cell}^{ON}$ est égale à la somme de la résistance mémoire basse $R_{cell}^{ON}$ de la cellule, et de la résistance de ligne $R_{line}$ (cette dernière étant généralement négligeable, en pratique) :

$$R'_{cell}^{ON} = R_{cell}^{ON} + R_{line} = R_{ON}^{sel} + R_{SET}^{RRAM} + R_{line}$$

Différentes précautions sont à prendre concernant le courant maximal $I_{max}$.

Tout d'abord, il est souhaitable que le courant maximal $I_{max}$ soit inférieur à un courant de programmation de la cellule, $I_{prog}$, au-delà duquel il y a un risque de modifier l'état résistif de l'élément mémoire 22, ce qui se traduit par :

$$V_{init}/R_{tot}^{ON} < I_{prog} \qquad (F1)$$

La résistance additionnelle $R_{add}$ permet, de manière particulièrement commode, d'ajuster la valeur de la résistance effective totale basse $R_{tot}^{ON}$, afin de satisfaire la condition (F1) ci-dessus. Cette possibilité d'ajustement de $R_{tot}^{ON}$ grâce à la résistance additionnelle $R_{add}$ est particulièrement intéressante pour une mémoire de type OxRAM, comme celle décrite ici, pour laquelle le courant maximal de lecture est souvent assez proche du courant de programmation.

Il est souhaitable aussi que le courant maximal $I_{max}$ soit supérieur au courant de maintien $I_h$, pour faire effectivement basculer le sélecteur dans son état conducteur, soit

$$V_{init}/R_{tot}^{ON} > I_h \qquad (F2)$$

Plus généralement, il est intéressant que le courant de décharge soit élevé (sans pour autant dépasser $I_{prog}$), pour décharger le plus possible le condensateur de conversion avant le reblocage du sélecteur. Cela permet en effet une chute substantielle de la tension aux bornes du condensateur, et donc une différence plus importante entre la tension de résultat de lecture pour un état hautement résistif et pour un état bassement résistif.

Il est souhaitable par ailleurs de décharger un minimum le condensateur de conversion pour éviter un phénomène d'oscillations entre le condensateur de conversion et la cellule mémoire. En effet, si le condensateur de conversion n'est pas suffisamment déchargé lorsque le sélecteur se rebloque, ce condensateur chargera ensuite (par répartition de charges) les capacités parasites de la mémoire, faisant ainsi repasser la tension aux bornes de la cellule à une valeur supérieure à $V_{th}^{SET}$ et entrainant ainsi un nouveau basculement du sélecteur dans son état conducteur, ce qui fera se décharger le condensateur de conversion jusqu'au reblocage du sélecteur, et ainsi de suite jusqu'à ce que le condensateur de conversion soit suffisamment déchargé, sa charge résiduelle ne permettant plus d'atteindre $V_{th}^{SET}$ aux bornes de la cellule mémoire. Ce phénomène d'oscillation est illustré sur la figure 11B, qui montre l'évolution au cours du temps t de $U_4$ et $i_{20}$, ainsi que de la tension $U_{21}$ aux bornes du sélecteur 21 seul, et de la tension $U_{22}$ aux bornes de l'élément mémoire 22 seul. Ces oscillations sont indésirables, ne serait-ce que parce qu'elles rallongent l'opération de lecture. Pour les éviter, il est souhaitable d'atteindre, à la fin de la première décharge (lorsque le sélecteur se rebloque), une tension suffisamment basse aux bornes du condensateur de conversion, ce qui se traduit par :

$$R_{tot}^{ON} < V_{th}^{SET}/I_h \qquad (F3)$$

A nouveau, ajuster la valeur de la résistance additionnelle $R_{add}$ permet d'ajuster commodément la valeur de $R_{tot}^{ON}$ de manière à satisfaire cette condition.

Pour ce qui est maintenant de la durée $t_{dis}$ de la troisième phase, elle peut s'exprimer comme :

$$t_{dis} = -\ln\left(\frac{I_h \times R_{tot}^{ON}}{V_{th}^{SET}}\right) \times \tau_{ON}$$

où $\tau_{ON} = R_{tot}^{ON} \times \left(C_c + C_{par}^{tot}\right)$ est le temps de réponse du circuit RC équivalent à la mémoire, dans cette situation.

A l'instant de re-blocage du sélecteur, à la fin de la troisième phase, le condensateur de conversion présente à ses bornes une tension $V_{read}^{SET}$ qui peut s'exprimer comme :

$$V_{read}^{SET} = V_{th}^{SET}.exp(-t_{dis}/\tau_{ON}) = I_h \times R_{tot}^{ON}$$

Pour obtenir une tension de résultat de lecture la plus basse possible, il est souhaitable d'attendre la fin de cette troisième phase avant de déconnecter le condensateur de conversion de la matrice et de mesure la tension à ses bornes. Il est donc souhaitable que la durée de lecture $t_{meas}$ soit supérieure à la somme de $t_{ch}$ et de tdis :

$$t_{meas} > t_{meas,min} = t_{ch} + t_{dis} \qquad (F4)$$

On peut même prévoir que la durée de lecture $t_{meas}$ soit supérieure à la somme de la durée $t_{meas,min}$ et d'une durée d'incubation maximale attendue $t_{incub}$.

Une <u>quatrième phase</u> « 4 » de l'opération de lecture débute lorsque le sélecteur rebascule dans son état bloqué, et s'achève à la fin de la durée de lecture $t_{meas}$, lorsque le condensateur de lecture est déconnecté de la matrice (afin de mesurer la tension de résultat de lecture, au cours d'une cinquième phase « 5 »).

Ici, on considère que, pendant la quatrième phase, la chute de tension aux bornes du condensateur de conversion due aux courants de fuite est négligeable. En effet, la tension électrique appliquée à la ligne $L_i$ est alors fortement réduite (du fait de la décharge préalable du condensateur).

La tension de résultat de lecture $V_R$ obtenue finalement à la fin de la quatrième phase est donc égale, ou tout au moins proche de la tension $V_{read}^{SET}$ à la fin de troisième phase.

Finalement, la différence $\Delta V_R$ entre : la tension de résultat de lecture $V_R$ pour un élément mémoire dans son état hautement résistif, et la tension de résultat de lecture $V_R$ pour un élément mémoire dans son état bassement résistif s'exprime alors comme $\Delta V_R = V_{read}^{RESET} - V_{read}^{SET}$.

<u>Dimensionnement</u>

Au vu du fonctionnement attendu pour la mémoire 1, il apparait utile de dimensionner les composants du dispositif d'interfaçage 3 conformément aux conditions données ci-dessous.

L'intérêt de ces conditions de dimensionnement est illustré par l'analyse du fonctionnement faite ci-dessus, sur la base du modèle électrique simplifié de la mémoire présenté plus haut. Mais, comme cela apparaitra à l'homme du métier, les comportements et tendances générales ainsi illustrées ne se limitent pas au cadre de l'analyse simplifiée en question, et les conditions de dimensionnement en question présentent un intérêt au-delà du cadre de ce modèle électrique simplifié.

Tout d'abord, on pourra noter que, pour pouvoir atteindre (aux bornes de la cellule 20S) une tension supérieure au seuil de tension bas $V_{th}^{SET}$, à la fin de la phase « 2 » de répartition de charges (et être ainsi en mesure de lire convenablement la cellule mémoire), il est souhaitable que la tension initiale $V^{init}$ et la capacité $C_c$ du condensateur de conversion 4 satisfassent la condition suivante :

$$V_{init} \geq V_{th}^{SET} \times \alpha \quad (F5)$$

où $\alpha = \left(C_c + C_{par}^{tot}\right)/C_c$ est un coefficient de compensation de répartition de charges.

Par ailleurs, pour éviter de risquer de réécrire la cellule mémoire lors de sa lecture, il est souhaitable de vérifier la condition suivante (pour que la tension aux bornes de la cellule reste inférieure au seuil de tension haut $V_{th}^{RESET}$ ) :

$$V_{init} \leq V_{th}^{RESET} \times \alpha \quad (F6)$$

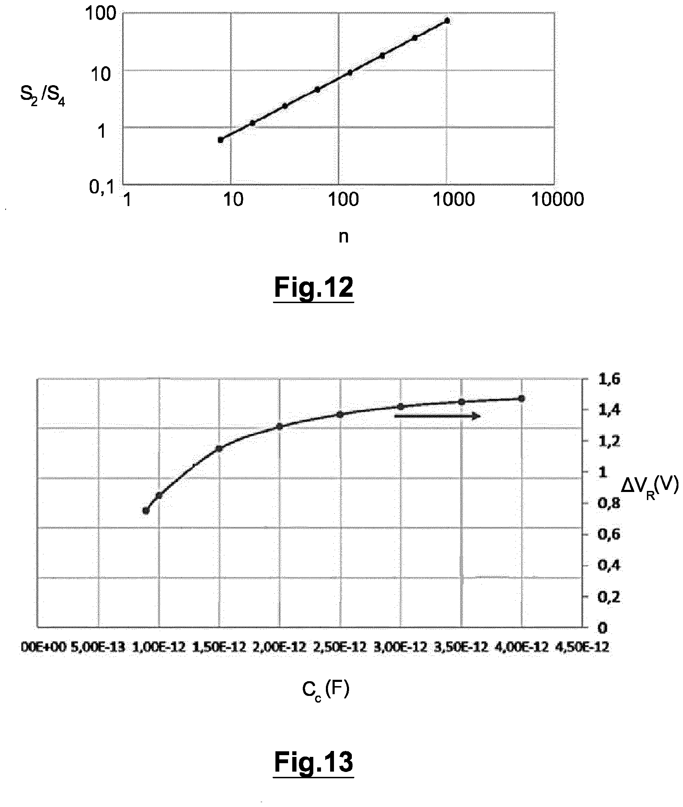

Pour pouvoir travailler avec une tension initiale $V^{init}$ qui ne soit pas excessivement élevée, si possible du même ordre de grandeur que les seuils de tension des cellules mémoire (autrement dit, pour avoir un coefficient $\alpha$ pas trop élevé), il est donc souhaitable que la capacité $C_c$ du condensateur de conversion soit supérieure, et même nettement supérieure à la capacité parasite globale $C_{par}^{tot}$. Cela est d'ailleurs souhaitable pour l'ensemble du fonctionnement de la mémoire 1. La figure 13 montre plus précisément, pour un exemple, l'influence de la valeur de capacité $C_c$ sur la largeur $\Delta V_R$ de la « fenêtre » entre tensions de lecture haute et basse, montrant qu'il est souhaitable de choisir la capacité $C_c$ suffisamment grande (par rapport à $C_{par}^{tot}$ ) pour obtenir une fenêtre de lecture suffisamment large.

En revanche, augmenter considérablement la valeur de Cc serait défavorable du point de vue de la durée minimale $t_{meas,min}$ de l'opération de lecture, et en termes d'énergie électrique consommée (C.f. : figure 14), sans pour autant améliorer notablement la largeur $\Delta V_R$ de la fenêtre de lecture (C.f. : effet de saturation de $\Delta V_R$, sur la figure 13)

Pour la capacité $C_c$, choisir par exemple une valeur comprise entre deux fois et trente fois la capacité parasite globale $C_{par}^{tot}$ permet d'obtenir un bon compromis entre ces différentes contraintes.

Pour ce qui est de la résistance additionnelle $R_{add}$, elle est choisie de préférence de manière à ce que la résistance effective totale basse $R_{tot}^{ON}$ soit inférieure à $V^{init}$ divisée $I_h$ (condition F2 donnée plus haut), voire inférieure à $V_{th}^{SET}/I_h$ (condition F3 donnée ci-dessus - qui permet d'éviter un régime oscillatoire), et supérieure à $V^{init}$ divisée $I_{prog}$ (condition F1 - qui permet de limiter les risques de réécriture à la lecture).

Pour mémoire, la résistance effective totale basse $R_{tot}^{ON}$ est la résistance effective totale dans laquelle se décharge le condensateur de conversion 4 lorsqu'il est connecté à la cellule mémoire 20S, la cellule présentant sa résistance mémoire basse $R_{cell}^{ON}$ (i.e. : élément mémoire dans son état bassement résistif, et sélecteur dans son état conducteur). La résistance effective totale basse $R_{tot}^{ON}$ peut s'exprimer de manière approchée, en fonction de la résistance additionnelle $R_{add}$ à ajuster, comme :

$$R_{tot}^{ON} = 1/(1/R_{leak}^{mat} + 1/R_{cell}^{ON}) + R_{add}$$

Enfin, pour ce qui est de la durée de lecture $t_{meas}$, elle pourra être choisie en pratique de manière à satisfaire la condition F4 donnée plus haut.

_Exemples numériques_

Un exemple de dimensionnement des composants du dispositif d'interfaçage 3 est donné ci-dessous, à titre illustratif, dans un cas où la matrice de cellules mémoires, de type OxRAM, présente les caractéristiques suivantes :

- résistance de l'élément mémoire dans l'état SET : $R_{SET}^{RRAM} = 10\text{k}\Omega$ ,

- résistance de l'élément mémoire dans l'état RESET : $R_{RESET}^{RRAM} = 100\text{k}\Omega$ ,

- résistance du sélecteur (de type OTS) à l'état passant : $R_{ON}^{sel} = 1\text{k}\Omega$ ,

- courant de maintien du sélecteur : $I_h$ = 100µA,

- courant de programmation : $I_{prog}$ = 200µA,

- seuil de tension bas $V_{th}^{SET}$=3,5V ,

- seuil de tension haut $V_{th}^{RESET}$=4V ,

- courant de seuil du sélecteur : $It_h$ = 1 µA,

- configuration de polarisation de type V/2, avec, pour les cellules partiellement sélectionnée, $V_{leak} = V_{th}^{SET}/2 = 1,75V$ ,

- courant de fuite à V/2 : $I_{leak}$ =10$^{-8}$A,

- dimensions de la matrice : m $\times$ n = 128x128, et

- capacité parasite élémentaire (pour une cellule) $C_{par}$ = 0,5fF.

Les conditions mentionnées plus haut, portant sur les caractéristiques du dispositif d'interfaçage 3, peuvent alors être satisfaites en choisissant les valeurs suivantes, par exemple :

- capacité du condensateur de conversion : $C_c$=2pF,

- tension initiale : 3,72 V < $V^{init}$ < 4,26 V, satisfait ici en choisissant $V^{init}$ = 4 V,

- résistance effective totale basse : $17,5\ k\Omega < R_{tot}^{ON} < 35\ k\Omega$ , ce qui peut être obtenu par exemple avec $R_{add}$ = 14,2 kΩ (ce qui correspond alors à un courant maximal $I_{max}$ = 139 µA).

Par ailleurs, avec ces paramètres la durée minimale de lecture $t_{meas,min}$ vaut 178 ns, avec $t_{ch}$=160 ns et $t_{dis}$=18 ns. La durée intrinsèque à l'opération de lecture en elle-même, qui est $t_{dis}$=18 ns, est donc courte (en revanche, le temps de charge des capacités parasites, $t_{ch}$, est plutôt important, et il serait intéressant de le réduire).

En choisissant alors $t_{meas}$ = 200 ns, on obtient les valeurs suivantes, pour la tension de résultat de lecture : $V_{read}^{RESET}$=3,8V, $V_{read}^{SET}$=2,5V , et une fenêtre de lecture $\Delta V_R$=1,3V.

Dans cet exemple, le temps de charge des capacités parasites $t_{ch}$ est bien plus important que le temps de lecture intrinsèque $t_{dis}$. Pour diminuer $t_{ch}$, on peut réduire la valeur des capacités parasites (ou, dans une moindre mesure, augmenter la tension initiale $V_{init}$). Un temps de lecture total inférieur à 50ns peut par exemple être envisagé en reprenant les mêmes paramètres que ci-dessus, mais en diminuant la valeur de la capacité parasite élémentaire $C_{par}$ à 0,1fF. Dans ce cas, le temps de charge des capacités parasites est $t_{ch}$ = 32 ns tandis que $t_{dis}$ = 17 ns, permettant un temps de lecture minimum de 49 ns et une fenêtre de lecture d'environ 1,4V pour une durée de lecture $t_{meas}$ = 50ns.

La figure 12 représente le rapport $S_2/S_4$ entre la surface $S_2$ occupée par la matrice 2 et une surface S4 occupée par le condensateur de conversion 4, en fonction du nombre n de lignes de la matrice, pour une matrice carrée (n=m).

En termes de densité spatiale de points mémoire (pour la matrice), et de capacité par unité de surface (pour le condensateur de conversion), les données de la figure 12 correspondent à des caractéristiques typiques d'un procédé de fabrication avec gravure fine (avec un pitch entre lignes compris par exemple entre 20 et 40 nanomètres).

Par ailleurs, la valeur de capacité $C_c$ correspondant à la surface $S_4$ est la plus petite valeur de $C_c$ permettant de satisfaire la condition F5 données plus haut, dans les mêmes conditions que pour l'exemple numérique complet présenté plus haut (en particulier, pour $V_{init}$=4V).

Comme on peut le voir sur cette figure, sauf pour des matrices de très petites dimensions, le rapport $S_2/S_4$ est supérieur à 1 (pour l'exemple numérique donnée plus haut, il est égal à 10, par exemple). Le condensateur de conversion ainsi réalisé occupe donc une surface plus petite que celle de la matrice.

Il peut alors être réalisé sur ou sous la matrice, à l'aplomb de celle-ci, sans déborder de la surface occupée par la matrice 2. Cela permet d'intégrer le condensateur de conversion au plus près de la matrice, et sans augmenter l'encombrement de la mémoire 1.

L'augmentation du rapport $S_2/S_4$ avec la dimension n, visible sur la figure 12, peut s'expliquer ainsi. La surface S2 de la matrice augmente comme $n^2$, tandis que la capacité parasite globale $C_{par}^{tot}$, et donc la valeur minimale de la capacité $C_c$, augmentent comme n (plus précisément, proportionnellement, comme 2n-1), si bien que le rapport $S_2/S_4$ augmente finalement avec n.

Sur les figures 13 et 14, on a représenté des valeurs obtenues pour la fenêtre de lecture $\Delta V_R$ (exprimée en volts, V) le temps de décharge $t_{dis}$ (en nanosecondes), et l'énergie E consommée lors d'une opération de lecture d'un état SET (exprimée en joules), en fonction de la valeur de la capacité $C_c$ du condensateur de conversion (en Farads). Ces valeurs sont obtenues dans les mêmes conditions que pour l'exemple numérique complet présenté plus haut (en particulier, $C_{par}$=0,5fF, pour ces figures).

Comme déjà mentionné, on constate que la fenêtre de lecture $\Delta V_R$ augmente avantageusement lorsque $C_c$ augmente, mais que cela s'accompagne aussi d'une augmentation du temps de décharge $t_{dis}$ (temps « intrinsèque » de lecture), et de l'énergie E consommée.

La figure 15 montre :

- l'énergie E est consommée lors d'une opération de lecture d'un état SET (en Joules) pour le dispositif d'interfaçage 3 particulier qui vient d'être présenté, et

- l'énergie E' consommée lors d'une opération de lecture d'un état SET (en Joules) pour un dispositif d'interfaçage conventionnel, dans lequel la lecture serait réalisée en appliquant une tension de lecture constante (voir la figure 1), en l'occurrence égale à 4V.

Les quatre valeurs d'énergie E, données respectivement pout $C_c$=1, 2, 3 et 4 pF, sont celles correspondant à la courbe de la figure 14.

Pour l'énergie E', 4 courbes sont représentées, associées respectivement à un courant de lecture $I_{read}$ de 100, 120, 150 et 200 microampères. Pour chacune de ces courbes, l'énergie E' est représentée en fonction d'une durée moyenne à l'état passant $t_{ON}$. Cette durée correspond au temps moyen pendant lequel la cellule mémoire (et en particulier son sélecteur) est conductrice.

A titre d'exemple, si le temps d'incubation mentionné plus haut fluctue, d'une cellule et d'une lecture à l'autre, entre 0 ns et 50ns, il faudra par exemple une impulsion de lecture (figure 1) durant 50ns au moins, ce qui conduit à une durée moyenne à l'état passant $t_{ON}$ de 25ns environ (il s'agit d'un exemple très schématique, mais quoiqu'il en soit, en pratique, $t_{ON}$ est typiquement comprise entre une dizaine et quelques dizaines de ns). Dans ce cas, on voit bien que les valeurs d'énergie E' obtenues par une technique de lecture conventionnelle sont plus élevées que l'énergie E consommée avec le dispositif d'interfaçage 3 qui vient d'être présenté, pour la valeur $C_c$=2pF mentionnée plus haut. Et cette conclusion reste valable pour les différentes valeurs de $t_{ON}$ envisagées, quitte éventuellement à adapter la valeur de Cc.

En plus de la mémoire 1 qui vient d'être décrite, l'invention concerne un procédé d'interfaçage d'une telle mémoire 1, comprenant les étapes suivantes :

- commander les premier et deuxièmes interrupteurs 5, 6 pour connecter la source 7 au condensateur de conversion 4, le condensateur de conversion étant alors déconnecté desdites pistes électriques de ligne et de colonne $L_i$, $C_j$, de manière à charger le condensateur de conversion 4 jusqu'à la tension d'initialisation $V_{init}$, puis

- commander les premier et deuxième interrupteurs 5, 6 pour déconnecter la source 7 du condensateur de conversion 4 et connecter ce condensateur entre ladite piste électrique de ligne $L_i$ et ladite piste électrique de colonne $C_j$.

Ce procédé peut en particulier être un procédé de lecture, dans lequel :

- les premier et deuxièmes interrupteurs 5, 6 sont pour déconnecter la source 7 du condensateur de conversion 4 et connecter le condensateur entre ladite piste électrique de ligne $L_i$ et ladite piste électrique de colonne $C_j$, pendant la durée de lecture $t_{meas}$ de cellule mémoire mentionnée plus haut,

- le procédé comprenant ensuite une étape d'acquisition de la tension de résultat de lecture $V_R$ aux bornes 11, 12 du condensateur de conversion 4, au moyen du dispositif de mesure de tension 8.

Ce procédé peut comprendre ensuite une étape de détermination de la donnée (0 ou 1, par exemple) stockée dans la cellule mémoire 20S, en fonction de la tension de résultat de lecture $V_R$.

**Revendications**

1. Mémoire (1) comprenant :

   - une matrice (2) de cellules (20) mémoires résistives avec :

     o des pistes électriques de ligne ($L_1$, $L_i$, $L_n$),
     o des pistes électriques de colonne ($C_1$, $C_j$, $C_m$), et
     o des cellules (20) mémoire résistives situées aux croisements entre les pistes électriques de ligne ($L_1$, $L_i$, $L_n$) et les pistes électriques de colonne ($C_1$, $C_j$, $C_m$), chaque cellule (20) mémoire étant connectée entre, d'une part, l'une des pistes électriques de ligne et, d'autre part, l'une des pistes électriques de colonne,

   - la mémoire (1) comprenant un dispositif d'interfaçage (3) pour interfacer ladite matrice (2), le dispositif d'interfaçage comprenant au moins un condensateur de conversion (4), un dispositif de mesure de tension (8) connecté aux bornes du condensateur de conversion (4), une source (7) électrique, un premier interrupteur (5), un deuxième interrupteur (6) et un module de commande (10), le dispositif d'interfaçage (3) étant configuré pour exécuter les étapes suivantes :

     o étape a) : connecter le condensateur de conversion (4) à la source (7) au moyen du deuxième interrupteur (6) pour charger le condensateur de conversion (4), puis
     o étape b) :

       - déconnecter le condensateur de conversion (4) de la source (7), et connecter le condensateur de conversion (4) entre l'une des pistes électriques de ligne ($L_i$) et l'une des pistes électriques de colonne ($C_j$), au moyen du premier interrupteur (5), puis
       - acquérir une tension de résultat de lecture ($V_R$), aux bornes (11, 12) du condensateur de conversion (4), au moyen du dispositif de mesure de tension (8), puis
       - détermination d'un état résistif de ladite cellule (20S) par le module de commande (10), sur la base de ladite tension de résultat de lecture ($V_R$).

2. Mémoire (1) selon la revendication précédente, dans laquelle le dispositif d'interfaçage (3) comprend une résistance additionnelle ($R_{add}$) connectée en série avec le condensateur de conversion (4).

3. Mémoire (1) selon l'une des revendications précédentes, dans laquelle le condensateur de conversion (4) a une capacité ($C_c$) supérieure à une capacité parasite globale ($C_{par}^{tot}$), cette capacité parasite globale étant représentative d'une capacité électrique effective de la partie de la matrice (2) correspondant à ladite piste électrique de ligne ($L_i$) et à ladite piste électrique de colonne ($C_j$).

4. Mémoire (1) selon l'une des revendications précédentes, dans laquelle le module de commande (10) est configuré pour commander les premier et deuxième interrupteurs (5, 6) de manière à exécuter les étapes a) et b).

5. Mémoire (1) selon la revendication 4, dans laquelle le module de commande (10) est configuré en outre pour :

   - A l'étape a), commander le deuxième interrupteur (6), ou la source (7), de manière à charger le condensateur de conversion (4) jusqu'à une tension d'initialisation ($V^{init}$) donnée,
   - A l'étape b), commander les premier et deuxième interrupteurs (5,6) de manière à déconnecter la source (7) du condensateur conversion (4), puis à connecter le condensateur de conversion (4) entre ladite piste électrique de ligne ($L_i$) et ladite piste électrique de colonne ($C_j$), pendant une durée de lecture ($t_{meas}$) de cellule mémoire prédéterminée, avant l'acquisition de ladite tension de résultat de lecture ($V_R$).

6. Mémoire (1) selon l'une des revendications précédentes,

   - dans laquelle chaque cellule mémoire (20) comprend un élément mémoire (22) ayant au moins un état hautement résistif (RESET) et un état bassement résistif (SET), ainsi qu'un sélecteur (21) agencé en série avec l'élément mémoire (22), le sélecteur étant électriquement conducteur lorsqu'une tension à ses bornes est supérieure à un seuil ($V_{th}^{Sel}$) donné, et étant électriquement isolant sinon,

- et dans laquelle, lorsqu'on applique aux bornes de la cellule mémoire (20) une tension (U) comprise entre un seuil de tension bas ( $V_{th}^{SET}$ ) et un seuil de tension haut ( $V_{th}^{RESET}$ ) :

  o si l'élément mémoire (22) est dans son état bassement résistif (SET), alors, le sélecteur devient électriquement conducteur et la cellule mémoire (20) présente alors une résistance mémoire basse ( $R_{cell}^{ON}$ ),

  o tandis que si l'élément mémoire (22) est dans son état hautement résistif (RESET), alors, le sélecteur reste électriquement isolant et la cellule mémoire (20) présente alors une résistance mémoire haute ( $R_{cell}^{OFF}$ ).

7. Mémoire (1) selon les revendications 5 et 6, dans laquelle ladite tension d'initialisation ($V^{init}$) est :

   - Supérieure audit seuil de tension bas ( $V_{th}^{SET}$ ), multiplié par un coefficient ($\alpha$) de compensation de répartition de charges, et

   - Inférieure audit seuil de tension haut ( $V_{th}^{RESET}$ ), multiplié de ledit coefficient ($\alpha$),

   - le coefficient ($\alpha$) de compensation de répartition de charges étant égal à la somme de la capacité du condensateur de conversion ($C_c$) et d'une capacité parasite globale ( $C_{par}^{tot}$ ), divisée par la capacité du condensateur de conversion ($C_c$), la capacité parasite globale ( $C_{par}^{tot}$ ) étant représentative de la capacité électrique effective de la partie de la matrice (2) correspondant à ladite piste électrique de ligne ($L_i$) et à ladite piste électrique de colonne ($C_j$).

8. Mémoire (1) selon la revendication 7, dans laquelle la durée de lecture ($t_{meas}$) est supérieure à : une résistance effective totale haute ( $R_{tot}^{Off}$ ), multipliée par ladite capacité parasite globale ( $C_{par}^{tot}$ ), la résistance effective totale haute ( $R_{tot}^{Off}$ ) étant une résistance effective totale dans laquelle se décharge le condensateur de conversion (4) lorsqu'il est connecté à ladite piste électrique de ligne ($L_i$) et à ladite piste électrique de colonne ($C_j$), la cellule mémoire (20S), située au croisement de cette ligne et de cette colonne, présentant sa résistance mémoire haute ( $R_{cell}^{OFF}$ ).

9. Mémoire (1) selon les revendications 2, 5 et 6,

   - dans laquelle le sélecteur (21) est électriquement conducteur à condition en outre qu'un courant électrique (i) qui traverse le sélecteur (21) reste supérieur à un courant de maintien ($I_h$),

   - et dans laquelle la résistance additionnelle ($R_{add}$) est telle qu'une résistance effective totale basse ( $R_{tot}^{ON}$ ) de la mémoire est inférieure à ladite tension d'initialisation ($V^{init}$) divisée par le courant de maintien ($i_h$) du sélecteur, la résistance effective totale basse ( $R_{tot}^{ON}$ ) étant la résistance effective totale dans laquelle se décharge le condensateur de conversion (4) lorsqu'il est connecté à ladite piste électrique de ligne ($L_i$) et à ladite piste électrique de colonne ($C_j$), la cellule mémoire (20S), située au croisement de cette ligne et de cette colonne, présentant sa résistance mémoire basse ( $R_{cell}^{ON}$ ).

10. Mémoire (1) selon la revendication 9, dans laquelle la résistance additionnelle ($R_{add}$) est telle que la résistance effective totale basse ( $R_{tot}^{ON}$ ) de la mémoire est, en outre, inférieure audit seuil de tension bas ( $V_{th}^{SET}$ ) divisée par le courant de maintien ($i_h$) du sélecteur.

11. Mémoire (1) selon l'une des revendications précédentes, dans laquelle le condensateur de conversion (4) est situé sur ou sous la matrice (2) de cellules mémoire (20) et s'étend parallèlement à la matrice (2), la matrice (2) et le condensateur de conversion (4) étant superposés l'un à l'autre.

12. Procédé d'interfaçage d'une mémoire (1) conforme à l'une quelconque des revendications précédentes, comprenant les étapes suivantes :

- étape a) : connecter le condensateur de conversion (4) à la source (7) au moyen du deuxième interrupteur (6) pour charger le condensateur de conversion (4), puis
- étape b) :

o déconnecter le condensateur de conversion (4) de la source (7), et connecter le condensateur de conversion (4) entre l'une des pistes électriques de ligne ($L_i$) et l'une des pistes électriques de colonne ($C_j$), au moyen du premier interrupteur (5), puis

o acquérir une tension de résultat de lecture ($V_R$), aux bornes (11, 12) du condensateur de conversion (4), au moyen du dispositif de mesure de tension (8), puis

o détermination d'un état résistif de ladite cellule (20S) par le module de commande (10), sur la base de ladite tension de résultat de lecture ($V_R$).

13. Procédé selon la revendication précédente, la mémoire (1) comprenant le dispositif de mesure de tension (8) connecté aux bornes (11, 12) du condensateur de conversion (4), dans lequel :

- à l'étape a), le deuxième interrupteur (6), ou la source (7), est commandé de manière à charger le condensateur de conversion (4) jusqu'à une tension d'initialisation ($V^{init}$) donnée,
- à l'étape b), les premier et deuxième interrupteurs (5,6) sont commandés de manière à déconnecter la source (7) du condensateur conversion (4), puis de manière à connecter le condensateur de conversion (4) entre ladite piste électrique de ligne ($L_i$) et ladite piste électrique de colonne ($C_j$), pendant une durée de lecture ($t_{meas}$) de cellule mémoire prédéterminée, avant l'acquisition de ladite tension de résultat de lecture ($V_R$).

**Patentansprüche**

1. Speicher (1) bestehend aus:

- einer Matrix (2) aus resistiven Speicherzellen (20) mit:

o elektrischen Zeilenspuren ($L_1$, $L_i$, $L_n$),
o elektrischen Spaltenspuren ($C_1$, $C_j$, $C_m$), und
o resistiven Speicherzellen (20), die sich an den Kreuzungen zwischen den elektrischen Zeilenspuren ($L_1$,$L_i$,$L_n$) und den elektrischen Spaltenspuren ($C_1$,$C_j$,$C_m$) befinden, wobei jede Speicherzelle (20) zwischen einerseits einer der elektrischen Zeilenspuren und andererseits einer der elektrischen Spaltenspuren angeschlossen ist,

- wobei der Speicher (1) eine Schnittstellenvorrichtung (3) zum Anschließen der Matrix (2) umfasst und die Schnittstellenvorrichtung mindestens einen Wandlerkondensator (4), eine Spannungsmessvorrichtung (8), die mit den Anschlüssen des Wandlerkondensators (4) verbunden ist, eine elektrische Quelle (7), einen ersten Schalter (5), einen zweiten Schalter (6) und ein Steuermodul (10) umfasst, wobei die Schnittstellenvorrichtung (3) so konfiguriert ist, dass sie die folgenden Schritte ausführt:

o Schritt a): Verbinden des Wandlerkondensators (4) mit der Quelle (7) mittels des zweiten Schalters (6), um den Wandlerkondensator (4) aufzuladen, und dann
o Schritt b):

- Trennen des Wandlerkondensators (4) von der Quelle (7) und Verbinden des Wandlerkondensators (4) zwischen einer der elektrischen Zeilenspuren ($L_i$) und einer der elektrischen Spaltenspuren ($C_j$) mittels des ersten Schalters (5), und dann
- Erfassen einer Spannung nach dem Ergebnis eines Ablesens ($V_R$) an den Anschlüssen (11, 12) des Wandlerkondensators (4) mit Hilfe der Spannungsmessvorrichtung (8), und dann
- Bestimmen eines resistiven Zustands der Zelle (20S) durch das Steuermodul (10) auf der Grundlage der Spannung des abgelesenen Ergebnisses ($V_R$).

2. Speicher (1) nach dem vorhergehenden Anspruch, bei dem die Schnittstellenvorrichtung (3) einen zusätzlichen Widerstand ($R_{add}$) umfasst, der in Reihe mit dem Wandlerkondensator (4) geschaltet ist.

3. Speicher (1) nach einem der vorhergehenden Ansprüche, bei dem der Wandlerkondensator (4) eine Kapazität ($C_c$) aufweist, die größer als eine gesamte parasitäre Kapazität ist ( $C_{par}^{tot}$ ), wobei diese gesamte parasitäre Kapazität für eine effektive elektrische Kapazität des Teils der Matrix (2) repräsentativ ist, der der elektrischen Zeilenspur ($L_i$) und der elektrischen Spaltenspur ($C_j$) entspricht.

4. Speicher (1) nach einem der vorhergehenden Ansprüche, bei dem das Steuermodul (10) so konfiguriert ist, dass es den ersten und den zweiten Schalter (5, 6) so steuert, dass die Schritte a) und b) ausgeführt werden.

5. Speicher (1) nach Anspruch 4, bei dem das Steuermodul (10) zudem so konfiguriert ist, um:

- in Schritt a) den zweiten Schalter (6) oder die Quelle (7) so zu steuern, dass der Wandlerkondensator (4) bis zu einer gegebenen Initialisierungsspannung ($V^{init}$) aufgeladen wird,
- in Schritt b) den ersten und zweiten Schalter (5, 6) so zu steuern, dass die Quelle (7) von dem Wandlerkondensator (4) getrennt und dann der Wandlerkondensator (4) zwischen der elektrischen Zeilenspur ($L_i$) und der elektrischen Spaltenspur ($C_j$) für eine vorbestimmte Lesezeit der Speicherzelle ($t_{meas}$) verbunden wird, bevor die Spannung des abgelesenen Ergebnisses ($V_R$) erfasst wird.

6. Speicher (1) nach einem der vorhergehenden Ansprüche,

- in dem jede Speicherzelle (20) ein Speicherelement (22) mit mindestens einem hochohmigen Zustand (RESET) und einem niederohmigen Zustand (SET) sowie einen Selektor (21) umfasst, der in Reihe mit dem Speicherelement (22) angeordnet ist, wobei der Selektor elektrisch leitend ist, wenn eine Spannung an seinen Anschlüssen größer als ein Grenzwert ( $V_{th}^{Sel}$ ) ist, und ansonsten elektrisch isolierend ist,
- und in dem, wenn an den Anschlüssen der Speicherzelle (20) eine Spannung (U) angelegt wird, die zwischen einem niedrigen Spannungsgrenzwert ( $V_{th}^{SET}$ ) und einem hohen Spannungsgrenzwert ( $V_{th}^{RESET}$ ) liegt:

  o wenn das Speicherelement (22) in seinem niederohmigen Zustand (SET) ist, dann wird der Selektor elektrisch leitend und die Speicherzelle (20) hat dann einen niederohmigen Speicherwiderstand ( $R_{cell}^{ON}$ ),
  o während, wenn das Speicherelement (22) in seinem hochohmigen Zustand (RESET) ist, dann bleibt der Selektor elektrisch isolierend und die Speicherzelle (20) weist dann einen hohen Speicherwiderstand auf ( $R_{cell}^{OFF}$ ).

7. Speicher (1) nach den Ansprüchen 5 und 6, wobei die Initialisierungsspannung ($V_{init}$):

- größer ist als der untere Spannungsgrenzwert ( $V_{th}^{SET}$ ), multipliziert mit einem Koeffizienten ($\alpha$) für den Ausgleich der Ladungsverteilung, und
- kleiner ist als der obere Spannungsgrenzwert ( $V_{th}^{RESET}$ ), multipliziert mit dem Koeffizienten ($\alpha$),
- wobei der Koeffizient ($\alpha$) für den Ausgleich der Ladungsverteilung gleich der Summe aus der Kapazität des Wandlerkondensators ($C_c$) und einer gesamten parasitären Kapazität ( $C_{par}^{tot}$ ), geteilt durch die Kapazität des Wandlerkondensators ($C_c$) ist, wobei die gesamte parasitäre Kapazität ( $C_{par}^{tot}$ ) repräsentativ für die effektive elektrische Kapazität des Teils der Matrix (2) ist, der der elektrischen Zeilenspur ($L_i$) und der elektrischen Säulenspur ($C_j$) entspricht.

8. Speicher (1) nach Anspruch 7, bei dem die Lesedauer ($t_{meas}$) größer ist als: ein oberer effektiver Gesamtwiderstand ( $R_{tot}^{Off}$ ), multipliziert mit der gesamten parasitären Kapazität ( $C_{par}^{tot}$ ), wobei der obere effektive Gesamtwiderstand ( $R_{tot}^{Off}$ ) ein effektiver Gesamtwiderstand ist, in den sich der Wandlerkondensator (4) entlädt, wenn er mit der elektrischen Zeilenspur ($L_i$) und der elektrischen Spaltenspur ($C_j$) verbunden ist, wobei die Speicherzelle (20S), die sich an der Kreuzung dieser Zeile und dieser Spalte befindet, ihren oberen Speicherwiderstand aufweist ( $R_{cell}^{OFF}$ ).

9. Speicher (1) nach den Ansprüchen 2, 5 und 6,

   - bei dem der Selektor (21) elektrisch leitend ist, unter der weiteren Voraussetzung, dass ein elektrischer Strom (i), der durch den Selektor (21) fließt, größer als ein Haltestrom ($i_h$) bleibt,
   - und in dem der zusätzliche Widerstand ($R_{add}$) so beschaffen ist, dass ein niedriger effektiver Gesamtwiderstand ( $R_{tot.}^{ON}$ ) des Speichers kleiner ist als die Initialisierungsspannung ($V^{init}$) geteilt durch den Haltestrom ($i_h$) des Selektors, wobei der niedrige effektive Gesamtwiderstand ( $R_{tot}^{ON}$ ) der effektive Gesamtwiderstand ist, in den sich der Wandlerkondensator (4) entlädt, wenn er mit der elektrischen Zeilenspur ($L_i$) und der elektrischen Spaltenspur ($C_j$) verbunden ist, wobei die Speicherzelle (20S), die sich an der Kreuzung dieser Zeile und dieser Spalte befindet, ihren unteren Speicherwiderstand aufweist ( $R_{cell}^{ON}$ ).

10. Speicher (1) nach Anspruch 9, wobei der zusätzliche Widerstand ($R_{add}$) so beschaffen ist, dass der niedrige effektive Gesamtwiderstand ( $R_{tot.}^{ON}$ ) des Speichers zudem kleiner ist als der untere Spannungsgrenzwert ( $V_{th}^{SET}$ ), geteilt durch den Haltestrom ($i_h$) des Selektors.

11. Speicher (1) nach einem der vorhergehenden Ansprüche, in dem der Wandlerkondensator (4) auf oder unter der Matrix (2) der Speicherzellen (20) angeordnet ist und sich parallel zur Matrix (2) erstreckt, wobei die Matrix (2) und der Wandlerkondensator (4) einander überlagert sind.

12. Verfahren zur Schnittstellenbildung eines Speichers (1) gemäß einem der vorhergehenden Ansprüche, das die folgenden Schritte umfasst:

   - Schritt a): Verbinden des Wandlerkondensators (4) mit der Quelle (7) mittels des zweiten Schalters (6), um den Wandlerkondensator (4) aufzuladen, und dann
   - Schritt b):

      ∘ Trennen des Wandlerkondensators (4) von der Quelle (7) und Verbinden des Wandlerkondensators (4) zwischen einer der elektrischen Zeilenspuren ($L_i$) und einer der elektrischen Spaltenspuren ($C_j$) mittels des ersten Schalters (5), dann
      ∘ Erfassen einer Spannung nach dem Ergebnis eines Ablesens ($V_R$) an den Anschlüssen (11, 12) des Wandlerkondensators (4) mit Hilfe der Spannungsmessvorrichtung (8), und dann
      ∘ Bestimmen eines resistiven Zustands der Zelle (20S) durch das Steuermodul (10) auf der Grundlage der Spannung des abgelesenen Ergebnisses ($V_R$).

13. Verfahren nach dem vorhergehenden Anspruch, in dem der Speicher (1) die Spannungsmessvorrichtung (8) umfasst, die mit den Anschlüssen (11, 12) des Wandlerkondensators (4) verbunden ist, wobei:

   - in Schritt a) der zweite Schalter (6) oder die Quelle (7) so gesteuert werden, dass der Wandlerkondensator (4) bis zu einer gegebenen Initialisierungsspannung ($V^{init}$) aufgeladen wird,
   - in Schritt b) der erste und zweite Schalter (5, 6) so gesteuert werden, dass die Quelle (7) von dem Wandlerkondensator (4) getrennt und dann der Wandlerkondensator (4) zwischen der elektrischen Zeilenspur ($L_i$) und der elektrischen Spaltenspur ($C_j$) für eine vorbestimmte Lesezeit der Speicherzelle ($t_{meas}$) verbunden wird, bevor die Spannung des abgelesenen Ergebnisses ($V_R$) erfasst wird.

**Claims**

1. Memory (1) comprising:

   - a matrix (2) of resistive memory cells (20) with:

      ∘ line electrical tracks ($L_1$, $L_i$, $L_n$),

○ column electrical tracks ($C_1$, $C_j$, $C_m$), and
o resistive memory cells (20) located at the crossings between the line electrical tracks ($L_1$, $L_i$, $L_n$) and the column electrical tracks ($C_1$, $C_j$, $C_m$), each memory cell (20) being connected between, on the one hand, one of the line electrical tracks and, on the other hand, one of the column electrical tracks,

- the memory (1) comprising an interfacing device (3) for interfacing said matrix (2), the interfacing device comprising at least one conversion capacitor (4), a voltage measuring device (8) connected to the terminals of the conversion capacitor (4), an electrical source (7), a first switch (5), a second switch (6) and a control module (10), the interfacing device (3) being configured to execute the following steps:

o step a): connecting the conversion capacitor (4) to the source (7) by means of the second switch (6) to charge the conversion capacitor (4), then
o step b):

- disconnecting the conversion capacitor (4) from the source (7), and connecting the conversion capacitor (4) between one of the line electrical tracks ($L_i$) and one of the column electrical tracks ($C_j$), by means of the first switch (5), then
- acquiring a read result voltage ($V_R$), at the terminals (11, 12) of the conversion capacitor (4), by means of the voltage measuring device (8), then
- determining a resistive state of said cellule (20S), by the control module (10), based on said read result voltage ($V_R$).

2. Memory (1) according to the preceding claim, wherein the interfacing device (3) comprises an additional resistor ($R_{add}$) connected in series with the conversion capacitor (4).

3. Memory (1) according to one of the preceding claims, wherein the conversion capacitor (4) has a capacitance ($C_c$) greater than a global parasitic capacitance ( $C_{par}^{tot}$ ), this global parasitic capacitance being representative of an effective electrical capacitance of the portion of the matrix (2) corresponding to said line electrical track ($L_i$) and to said column electrical track ($C_j$).

4. Memory (1) according to one of the preceding claims, wherein the control module (10) is configured to control the first and second switches (5, 6) in such a way as to execute steps a) and b).

5. Memory (1) according to claim 4, wherein the control module (10) is further configured to:

- In step a), control the second switch (6), or the source (7), in such a way as to charge the conversion capacitor (4) to a given initialisation voltage ($V^{init}$),
- In step b), control the first and second switches (5,6) in such a way as to disconnect the source (7) from the conversion capacitor (4), then to connect the conversion capacitor (4) between said line electrical track ($L_i$) and said column electrical track ($C_j$), during a predetermined memory cell reading time ($t_{meas}$), before the acquisition of said read result voltage ($V_R$).

6. Memory (1) according to one of the preceding claims,

- wherein each memory cell (20) comprises a memory element (22) having at least one high resistive state (RESET) and one low resistive state (SET), as well as a selector (21) arranged in series with the memory element (22), the selector being electrically conductive when a voltage at its terminals is greater than a given threshold ( $V_{th}^{Sel}$ ), and being electrically insulating otherwise,
- and wherein, when a voltage (U), applied at the terminals of the memory cell (20), is comprised between a low voltage threshold ( $V_{th}^{SET}$ ) and a high voltage threshold ( $V_{th}^{RESET}$ ):

o if the memory element (22) is in its low resistive state (SET), then, the selector becomes electrically conductive and the memory cell (20) then has a low memory resistance ( $R_{cell}^{ON}$ ),
o while if the memory element (22) is in its high resistive state (RESET), then, the selector remains electrically insulating and the memory cell (20) then has a high memory resistance ( $R_{cell}^{OFF}$ ).

7. Memory (1) according to claims 5 and 6, wherein said initialisation voltage ($V^{init}$) is:

- Greater than said low voltage threshold ( $V_{th}^{SET}$ ), multiplied by a load balancing compensation coefficient ($\alpha$), and

- Less than said high voltage threshold ( $V_{th}^{RESET}$ ), multiplied by said coefficient ($\alpha$),
- the load balancing compensation coefficient ($\alpha$) being equal to the sum of the capacitance of the conversion capacitor ($C_c$) and of a global parasitic capacitance ( $C_{par}^{tot}$ ), divided by the capacitance of the conversion capacitor ($C_c$), with global parasitic capacitance ( $C_{par}^{tot}$ ) being representative of the effective electrical capacitance of the portion of the matrix (2) corresponding to said line electrical track ($L_i$) and to said column electrical track ($C_j$).

8. Memory (1) according to claim 7, wherein the reading time ($t_{meas}$) is greater than: a high total effective resistance ( $R_{tot}^{Off}$ ), multiplied by said global parasitic capacitance ( $C_{par}^{tot}$ ), the high total effective resistance ( $R_{tot}^{Off}$ ) being a total effective resistance in which the conversion capacitor (4) discharges when it is connected to said line electrical track ($L_i$) and to said column electrical track ($C_j$), the memory cell (20S), located at the crossing of this line and of this column, having its high memory resistance ( $R_{cell}^{OFF}$ ).

9. Memory (1) according to claims 2, 5 and 6,

- wherein the selector (21) is electrically conductive with the further condition that an electrical current (i) that passes through the selector (21) remains greater than a holding current ($I_h$),

- and wherein the additional resistor ($R_{add}$) is such that a low total effective resistance ( $R_{tot}^{ON}$ ) of the memory is less than said initialisation voltage ($V_{init}$) divided by the holding current ($i_h$) of the selector, the low total effective resistance ( $R_{tot}^{ON}$ ) being the total effective resistance in which the conversion capacitor (4) discharges when it is connected to said line electrical track ($L_i$) and to said column electrical track ($C_j$), the memory cell (20S), located at the crossing of this line and of this column, having its low memory resistance ( $R_{cell}^{ON}$ ).

10. Memory (1) according to claim 9, wherein the additional resistor ($R_{add}$) is such that the low total effective resistance ( $R_{tot}^{ON}$ ) of the memory is, furthermore, less than said low voltage threshold ( $V_{th}^{SET}$ ) divided by the holding current ($i_h$) of the selector.

11. Memory (1) according to one of the preceding claims, wherein the conversion capacitor (4) is located above or below the matrix (2) of memory cells (20) and extends parallel to the matrix (2), the matrix (2) and the conversion capacitor (4) being superimposed on each other.

12. Method for interfacing a memory (1) in accordance with any of the preceding claims, comprising the following steps:

- step a): connecting the conversion capacitor (4) to the source (7) by means of the second switch (6) to charge the conversion capacitor (4), then
- step b):

o disconnecting the conversion capacitor (4) from the source (7), and connecting the conversion capacitor (4) between one of the line electrical tracks ($L_i$) and one of the column electrical tracks ($C_j$), by means of the first switch (5), then
o acquiring a read result voltage ($V_R$), at the terminals (11, 12) of the conversion capacitor (4), by means of the voltage measuring device (8), then
o determining a resistive state of said cell (20S), by the control module (10), based on said read result voltage

$(V_R)$.

13. Method according to the preceding claim, the memory (1) comprising the voltage measuring device (8) connected to the terminals (11, 12) of the conversion capacitor (4), wherein:

- in step a), the second switch (6), or the source (7), is controlled in such a way as to charge the conversion capacitor (4) to a given initialisation voltage ($V^{init}$),
- in step b), the first and second switches (5,6) are controlled in such a way as to disconnect the source (7) from the conversion capacitor (4), then in such a way as to connect the conversion capacitor (4) between said line electrical track ($L_i$) and said column electrical track ($C_j$), during a predetermined memory cell reading time ($t_{meas}$), before the acquisition of said read result voltage ($V_R$).

**Fig.1**

**Fig.2**

**Fig.3**

**Fig.4**

**Fig.5**

**Fig.6**

**Fig.7**

**Fig.8**

**Fig.9**

**Fig.10**

**Fig.11**

**Fig.11B**

**Fig.12**

**Fig.13**

**Fig.14**

**Fig.15**

**RÉFÉRENCES CITÉES DANS LA DESCRIPTION**

**Documents brevets cités dans la description**

• US 2013329484 A1